# EUROPEAN PATENT SPECIFICATION

(11) **EP 4 468 321 B1**
(45) Date of publication and mention of the grant of the patent: **31.12.2025**
(21) Application number: 24176514.8
(22) Date of filing: 17.05.2024
(51) Int. Cl.: H01L 21/285, H01L 21/768, H01L 23/485, H10B 12/00

(54) **SEMICONDUCTOR DEVICE AND METHOD OF MANUFACTURING THE SAME**
HALBLEITERANORDNUNG UND VERFAHREN ZU DEREN HERSTELLUNG
DISPOSITIF SEMI-CONDUCTEUR ET SON PROCÉDÉ DE FABRICATION

(30) Priority: 25.05.2023 KR 20230067626
(43) Date of publication of application: 27.11.2024
(73) Proprietor: Samsung Electronics Co., Ltd., Suwon-si, Gyeonggi-do 16677 (KR)
(72) Inventor: KIM, Seokwon, 16677 Suwon-si (KR); KUH, Bongjin, 16677 Suwon-si (KR); KIM, Sukhoon, 16677 Suwon-si (KR); PARK, Jiho, 16677 Suwon-si (KR); YU, Sanghyeok, 16677 Suwon-si (KR); HA, Yongho, 16677 Suwon-si (KR); HASAN, Musarrat, 16677 Suwon-si (KR)
(74) Representative: Marks & Clerk LLP

(56) References cited:
- US-A1- 2002 180 043
- US-A1- 2019 097 012
- US-B1- 9 899 258
- BAR E ET AL: "Simulation of the influence of via sidewall tapering on step coverage of sputter-deposited barrier layers", MICROELECTRONIC ENGINEERING, ELSEVIER PUBLISHERS BV., AMSTERDAM, NL, vol. 64, no. 1-4, 1 October 2002 (2002-10-01), pages 321 - 328, XP004381201, ISSN: 0167-9317, DOI: 10.1016/S0167-9317(02)00805-5

## Description

### BACKGROUND

The present inventive concept relates to a semiconductor device and a method of manufacturing the same.

Research into reduction of the size of elements constituting semiconductor devices and improvement of performance is being conducted. For example, as the size of the contact hole decreases, defects may occur while filling the contact hole with a conductive material.

US2019/0097012A1 describes a method of forming a semiconductor device structure including forming an insulating layer over a substrate, forming an opening in the insulating layer to expose a conductive region, performing a deposition process to form a metal layer over a sidewall and bottom of the opening, etching at least a portion of the metal layer, and forming a fill metal layer in the opening.

US9899258B1 describes a method of forming a semiconductor device including forming a recess in a dielectric layer, depositing a metal to form conductive layers over an upper surface and sidewalls of the dielectric layer, and removing portions of the conductive layers.

US2002/0180043A1 describes a semiconductor device having a substrate, an interlayer dielectric layer formed on the substrate, and a through hole formed in the interlayer dielectric layer. A metal barrier layer is formed on the surfaces of the interlayer dielectric layer and the through hole.

### SUMMARY

Example embodiments provide a method of manufacturing a semiconductor device in which electrical characteristics may be improved.

Example embodiments provide a semiconductor device which may be manufactured by the disclosed method of manufacturing a semiconductor device.

According to example embodiments, a method of manufacturing a semiconductor device is provided. The method includes forming a structure having a contact hole exposing a first region, at least a portion of the contact hole having an inclined sidewall; and forming a metal-semiconductor compound layer on the first region exposed by the contact hole, by performing a semiconductor process at a metal-semiconductor compound formation temperature using process gases. The process gases include a first process gas containing a metal element and a second process gas generating plasma by plasma power applied to the second process gas. The forming the metal-semiconductor compound layer includes performing a first process of exposing the structure to the process gases in a state in which the plasma power is turned off; after the first process, repeating, two or more times, a second process and a third process following the second process, wherein the second process includes repeatedly alternating between a plasma process performed for a first time duration in which the plasma power is turned on and a process of exposing the structure to the process gases for a second time duration in which while the plasma power is turned off, and the third process includes exposing the structure to the process gases while the plasma power is turned off, wherein repeating of the second and third processes forms a preliminary sidewall material layer covering the inclined sidewall of the contact hole and a preliminary upper material layer covering an upper surface of the structure, and wherein a thickness of the preliminary upper material layer is greater than a thickness of the preliminary sidewall material layer; and after repeating the second process and the third process two or more times, performing a fourth process of exposing the structure to the process gases while the plasma power is turned off to reduce the thickness of the preliminary upper material layer and form an upper material layer remaining on the upper surface of the structure, and to remove at least a portion of the preliminary sidewall material layer.

According to example embodiments, a semiconductor device is provided. The semiconductor device includes a structure having a first region and a contact hole exposing the first region; and a conductive structure including a lower region within the contact hole and an upper region disposed on the lower region and the structure. At least a portion of the contact hole has an inclined sidewall. The conductive structure includes a metal-semiconductor compound layer in contact with the first region; a conductive pattern contacting the metal-semiconductor compound layer within the contact hole, and provided on the structure and covering an upper surface of the structure; and an upper material layer between the upper surface of the structure and the conductive pattern. The metal-semiconductor compound layer includes a first metal element and a semiconductor element, the upper material layer includes the first metal element, and the thickness of the metal-semiconductor compound layer is greater than the thickness of the upper material layer. The conductive pattern is either:
in contact with the inclined sidewall of the contact hole, or
the conductive structure further includes a sidewall material layer between the conductive pattern and the inclined sidewall of the contact hole, wherein the thickness of the upper material layer is greater than the thickness of the sidewall material layer, and wherein the thickness of the sidewall material layer is 1 nm or less.

At least some of the above and other features of the invention are set out in the claims.

### BRIEF DESCRIPTION OF DRAWINGS

The above and other aspects, features, and advantages of the present inventive concept will be more clearly understood from the following detailed description, taken in conjunction with the accompanying drawings, in which:
FIG. 1 is a schematic cross-sectional view of an illustrative example of a semiconductor processing apparatus for manufacturing a semiconductor device according to example embodiments;
FIGS. 2A and 2B are process flow charts schematically illustrating a method of manufacturing a semiconductor device according to example embodiments;
FIGS. 3, 4A, 4B, and 5A are cross-sectional views schematically illustrating a method of manufacturing a semiconductor device according to example embodiments;
FIG. 5B is a schematic cross-sectional view of a modified example of a semiconductor device according to example embodiments;
FIG. 6 is a graph illustrating the thickness of a side material layer formed by a method of manufacturing a semiconductor device according to the example embodiments;
FIG. 7 is a cross-sectional view schematically illustrating a modified example of a semiconductor device according to example embodiments;
FIG. 8 is a cross-sectional view schematically illustrating a modified example of a semiconductor device according to example embodiments;
FIG. 9 is a cross-sectional view schematically illustrating a modified example of a semiconductor device according to example embodiments;
FIG. 10 is a schematic cross-sectional view of a modified example of a semiconductor device according to example embodiments;
FIGS. 11, 12A, 12B, and 12C are process flow charts schematically illustrating a method of manufacturing a semiconductor device according to example embodiments;
FIGS. 13 to 17 are diagrams schematically illustrating a semiconductor device according to a method of manufacturing a semiconductor device according to the example embodiments;
FIG. 18 is a cross-sectional view schematically illustrating a modified example of a semiconductor device according to a method of manufacturing a semiconductor device according to example embodiments; and
FIGS. 19A and 19B are cross-sectional views schematically illustrating a modified example of a semiconductor device according to a method of manufacturing a semiconductor device according to example embodiments.

### DETAILED DESCRIPTION

The present disclosure now will be described more fully hereinafter with reference to the accompanying drawings, in which various embodiments are shown. It should also be emphasized that the disclosure provides details of alternative examples, but such listing of alternatives is not exhaustive. Furthermore, any consistency of detail between various examples should not be interpreted as requiring such detail - it is impracticable to list every possible variation for every feature described herein. The language of the claims should be referenced in determining the requirements of the invention.

The terminology used herein is for the purpose of describing particular embodiments only and is not intended to be limiting of the invention.

Hereinafter, spatially relative terms such as "upper," "middle," "lower," "beneath," "below," "above," "top," "bottom," and the like, may be used herein for ease of description to describe positional relationships, such as illustrated in the figures, for example. It will be understood that the spatially relative terms encompass different orientations of the device in addition to the orientation depicted in the figures. In addition, such spatially relative terms may be replaced with other terms, such as "first", "second" and "third" to describe the components of the specification.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

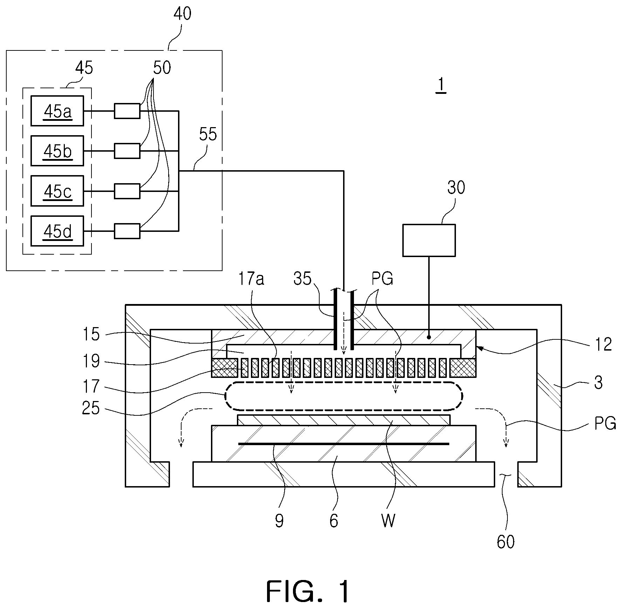

FIG. 1 is a cross-sectional view schematically illustrating an example of a semiconductor processing apparatus for manufacturing a semiconductor device according to example embodiments.

Referring to FIG. 1, a semiconductor processing apparatus 1 for manufacturing a semiconductor device according to example embodiments may include a process chamber 3, a wafer support 6 for supporting a substrate W in the process chamber 3, a heater 9 in the wafer support 6 for heating the substrate W, a showerhead structure 12 for providing a process gas on the substrate W supported by the wafer support 6, a process region 25 between the wafer support 6 and the showerhead structure 12, a high frequency power supply 30 capable of supplying radio frequency (RF) power to the showerhead structure 12, a gas discharge hole 35 for supplying process gases PG to the showerhead structure 12, a gas supply system 40 connected to the gas discharge hole 35 through a gas line 55, and an outlet 60 for discharging process gases PG from the process region 25 to the outside of the process chamber 3.

The substrate W may be a semiconductor wafer for manufacturing semiconductor devices.

The gas supply system 40 may include a gas supply device 45 capable of providing process gases PG required for manufacturing semiconductor devices, and mass flow controllers 50 capable of controlling the flow rate of a plurality of process gases PG provided from the gas supply device 45.

The gas supply device 45 may include a first gas supply source 45a for providing a first process gas, a second gas supply source 45b for providing a second process gas, a third gas supply source 45c for providing a third process gas, and a fourth gas supply source 45d for providing a fourth process gas.

The process gases PG may vary in type depending on the semiconductor process to be performed. For example, in a semiconductor process for depositing Ti, the process gases PG may include TiCl₄ gas, Ar gas, and H₂ gas. In another example, in a semiconductor process for depositing TiN, the process gases PG may include TiCl₄ gas, Ar gas, H₂ gas, and NH₃ gas.

The showerhead structure 12 may include a base 15, a shower plate 17 under the base 15, and a gas diffusion space 19 between the base 15 and the shower plate 17. The gas discharge hole 35 for supplying the process gases PG to the showerhead structure 12 may pass through the base 15 and be connected to the gas diffusion space 19. The process gases PG supplied to the gas diffusion space 19 may be supplied to the process region 25 through the holes 17a of the shower plate 17.

In this manner, a semiconductor process may be performed on the substrate W using the process gases PG supplied to the process region 25.

Hereinafter, a method of manufacturing a semiconductor device according to example embodiments and a semiconductor device manufactured by the method will be described.

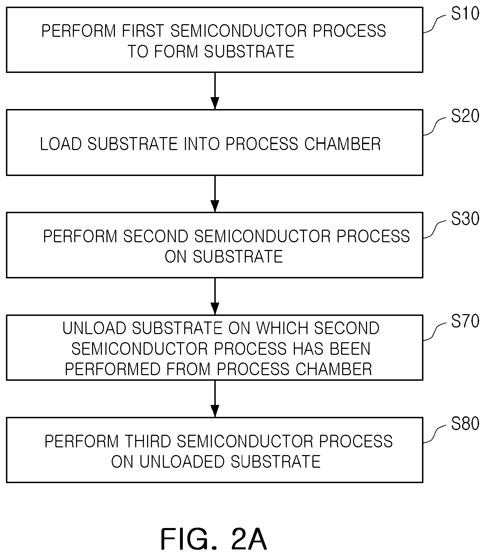

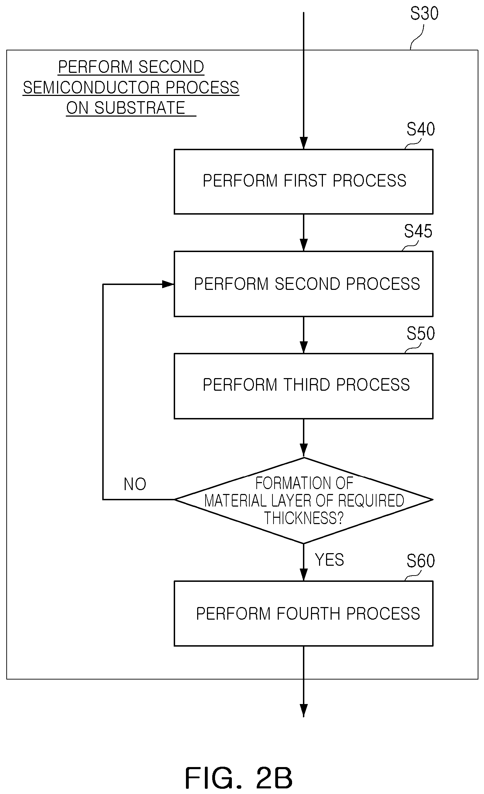

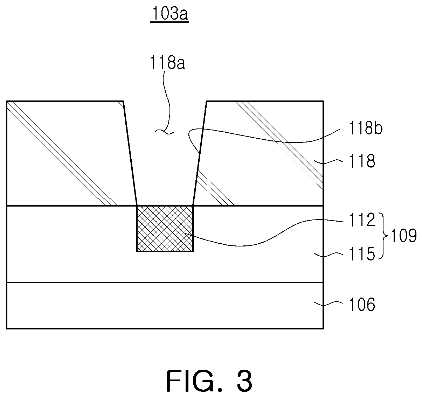

FIG. 2A is a process flow diagram schematically illustrating a method of manufacturing a semiconductor device according to example embodiments, FIG. 2B is a process flow diagram schematically illustrating some operations of the methods of FIG. 2A, and FIGS. 3, 4A, 4B, and 5A are cross-sectional views schematically illustrating a method of manufacturing a semiconductor device according to example embodiments. Referring to FIGS. 2A and 3, a first semiconductor process may be performed to form a substrate 103a (S10). The substrate 103a may include a semiconductor substrate 106, a first structure 109 on the semiconductor substrate 106, and a second structure 118 on the first structure 109.

The semiconductor substrate 106 may be formed of and/or include a semiconductor material, for example, a group IV semiconductor, a group III-V compound semiconductor, or a group II-VI compound semiconductor. For example, the group IV semiconductor may include silicon, germanium, or silicon-germanium. The semiconductor substrate 106 may be provided as a bulk semiconductor wafer, a semiconductor substrate including an epitaxial layer, a silicon on insulator (SOI) substrate, or a semiconductor on insulator (SeOI) substrate.

The first structure 109 may include a first region 112 and a peripheral area 115 around the first region 112. The first region 112 may be a conductive region formed by doping an impurity into a semiconductor material and may have a conductivity type determined by the impurity. For example, the first region 112 may be formed of and/or include doped Si, doped Ge, or doped SiGe. The first region 112 may be a source/drain region of a transistor, but embodiments are not limited thereto. For example, the first region 112 may be a conductive region constituting at least a portion of a contact plug. The peripheral area 115 may have a portion surrounding at least a side surface of the first region 112.

The second structure 118 may have a contact hole 118a exposing at least a portion of the first region 112. The second structure 118 may be an insulating structure formed of and/or including an insulating material such as silicon oxide or silicon nitride. The contact hole 118a may have an inclined side surface 118b. The contact hole 118a may have a side surface 118b having a positive slope. For example, the contact hole 118a may have a positively inclined side surface 118b such that the width of the upper region of the contact hole 118a is greater than the width of the lower region of the contact hole 118a.

The aspect ratio of the contact hole 118a may be greater than or equal to 3.5:1 (e.g., the depth of the contact hole 118a divided by the width of the contact hole 118a may be greater than or equal to 3.5).

The maximum width of the contact hole 118a may be 20 nm or less.

Referring to FIGS. 1, 2A, 2B, 4A, and 4B, the substrate 103a may be loaded into the process chamber 3 (S20). The substrate 103a may be loaded onto the substrate support 6 in the process chamber 3.

A second semiconductor process may be performed on the substrate 103a (S30). Performing the second semiconductor process on the substrate 103a may include performing the first process (S40), performing the second process (S45), performing the third process (S50), repeatedly performing the second process (S45) and third process (S50) when the material layer of the required thickness is not formed (e.g., repeat the second process (S45) and the third process (S50) until the required thickness of the material layer is obtained), and performing the fourth process (S60) when a material layer having a required thickness is formed.

In example embodiments, the second process (S45) and the third process (S50) may be repeated two or more times.

The operation of performing the second semiconductor process on the substrate 103a (S30) may be performed at a metal-semiconductor compound formation temperature (e.g., the temperature of the substrate 103a may be at the metal-semiconductor compound formation temperature). In some embodiments the formation temperature of the metal-semiconductor compound may be in the range of about 400°C to about 600°C. In other embodiments, the formation temperature of the metal-semiconductor compound may be in the range of about 500°C to about 600°C.

The operation of performing the first process (S40) may include supplying the process gases PG into the process chamber 3 and performing a process at a first process temperature for a first time without using plasma. The operation of performing the first process (S40) may include exposing the substrate 103a to the process gases PG in a state in which plasma power is turned off. In example embodiments, the plasma power may be Radio Frequency (RF) plasma power.

The operation of performing the second process (S45) may include supplying the process gases PG into the process chamber 3 and performing a process at a second process temperature for a second time, after the first process (S40). For example, the operation of performing the second process (S45) may include repeatedly performing a plasma process with the plasma power turned on and a process of exposing the substrate 103a to the process gases PG with the plasma power turned off. The second process may be a deposition process.

The operation of performing the third process (S50) may include performing a process at the second process temperature for a third time without using plasma while supplying the process gases PG into the process chamber 3. The operation of performing the third process (S50) may include a soak process of exposing the substrate 103a to the process gases PG in a state in which plasma power is turned off.

The operation of performing the fourth process (S60) may include supplying the process gases PG into the process chamber 3 and performing a process at a third process temperature for a fourth time without using plasma. The operation of performing the fourth process (S60) may include exposing the substrate 103a to the process gases PG while the plasma power is turned off.

The process gases PG may include a first process gas, a second process gas, and a third process gas. The first process gas may be supplied to the process region 25 from the first gas supply source 45a, the second process gas may be supplied to the process region 25 from the second gas supply source 45b, and the third process gas may be supplied to the process region 25 from the third gas supply source 45c.

The first process gas may include a metal element. The second process gas may generate plasma when the plasma power is applied. The third process gas may enhance reliability of the metal-semiconductor compound layer 121.

In an example embodiment, the first process gas may be TiCl₄ gas, the second process gas may be Ar gas, and the third process gas may be H₂ gas. The following example will be described based on an example in which the first process gas is TiCl₄ gas, the second process gas is Ar gas, and the third process gas is H₂ gas. However, embodiments are not limited to supplying these three process gases PG to the process region 25 in the process chamber 3.

The operation (S40) of performing the first process may include supplying the process gases (PG) into the process region 25 in the process chamber 3 at a temperature in the range of about 400°C to about 600°C for a time in the range of about 1 second to about 20 seconds, in a state in which the RF plasma power is turned off. In the first process, the flow rate of the TiCl₄ gas supplied to the process region 25 may be in the range of about 10 standard cubic centimeter per minute (sccm) to about 30 sccm, the flow rate of the Ar gas supplied to the process region 25 may be in the range of about 1500 sccm to about 2500 sccm, and a flow rate of the H₂ gas supplied to the process region 25 may be in the range of about 2000 sccm to about 6000 sccm.

The operation of performing the second process (S45) may include supplying the process gases (PG) into the process region 25 in the process chamber 3 at a temperature in the range of about 400°C to about 600°C for a time in the range of about 1 second to about 15 seconds. In the second process, the duty ratio of the plasma power may be in the range of about 10% to about 50%, the flow rate of the TiCl₄ gas supplied to the process region 25 may be in the range of about 10 sccm to about 30 sccm, the flow rate of the Ar gas supplied to the process region 25 may be in the range of about 1500 sccm to about 2500 sccm, and a flow rate of the H₂ gas supplied to the process region 25 may be in the range of about 2000 sccm to about 6000 sccm. In the second process, the RF plasma power may be about 100 watts (W) to about 1000 watts (W).

The operation of performing the third process (S50) may include supplying the process gases (PG) into the process region 25 in the process chamber 3 at a temperature in the range of about 400°C to about 600°C for a time in the range of about 0.6 seconds to about 30 seconds, with the RF plasma power off. In the third process, the flow rate of the TiCl₄ gas supplied to the process region 25 may be in the range of about 10 sccm to about 30 sccm, the flow rate of the Ar gas supplied to the process region 25 may be in the range of about 1500 sccm to about 2500 sccm, and a flow rate of the H₂ gas supplied to the process region 25 may be in the range of about 2000 sccm to about 6000 sccm.

In the operation of performing the second process (S45), the duty ratio may refer to a ratio of time during which the RF plasma power is turned on during the process time of the second process. For example, performing the second process (S45) may include repeating a state in which the RF plasma power is turned on and a state in which the RF plasma power is turned off, and in some embodiments, the RF duty ratio may be within a range of about 10% to about 50%.

In some embodiments, the duration of the third process, for example, the duration during which the RF plasma power was turned off during the third process, may be about 50 times to about 1000 times longer than the duration in which the RF plasma power is turned off in the second process. For example, when the RF plasma power is turned on and off in the second process, the duration of the third process may be 50 times to 1000 times longer than the duration of an off cycle during the second process.

In some embodiments, the duration of the third process, for example, the duration during which the RF plasma power was turned off during the third process, may be about 200 to about 600 times greater than the duration when the RF plasma power is turned off in the second process. For example, when the RF plasma power is turned on and off in the second process, the duration of the third process may be about 200 times to about 600 times longer than the duration of an off cycle of the second process.

The operation of performing the fourth process (S60) may include supplying the process gases (PG) into the process region 25 in the process chamber 3 at a temperature in the range of about 400°C to about 600°C for a time in the range of about 1 second to about 30 seconds, with the RF plasma power off. In the fourth process, the flow rate of the TiCl₄ gas supplied to the process region 25 may be in the range of about 10 sccm to about 30 sccm, the flow rate of the Ar gas supplied to the process region 25 may be in the range of about 1500 sccm to about 2500 sccm, and the flow rate of the H₂ gas supplied to the process region 25 may be in the range of about 2000 sccm to about 6000 sccm.

In an example embodiment, the process gases PG may further include a fourth process gas containing nitrogen. For example, the fourth process gas may include N₂ gas or NH₃ gas.

After repeating the second and third processes, a metal-semiconductor compound layer 121 having a first thickness may be formed on the first region 112, an upper material layer 127U may be formed on the upper surface 118U of the second structure 118, and a side material layer 127S may be formed on the side surface 118b of the contact hole 118a.

The thickness of the side material layer 127S may be smaller than (e.g., less than) the thickness of the upper material layer 127U. Thicknesses of an upper region ST, a middle region SM, and a lower region SB of the side material layer 127S may be smaller (e.g., less than) than the thickness of the upper material layer 127U. The upper material layer 127U and the side material layer 127S may be formed as one continuous material layer.

The metal-semiconductor compound layer 121 may be formed of and/or include a compound including a metal element and a semiconductor element. The upper material layer 127U and the side material layer 127S may be formed of and/or include a conductive material layer including the metal element.

The metal-semiconductor compound layer 121 may be formed of a compound including a metal element, a semiconductor element, and a nitrogen element. The upper material layer 127U and the side material layer 127S may be formed of and/or include a conductive material layer including the metal element and the nitrogen element.

The upper material layer 127U and the side material layer 127S may be formed of and/or include a conductive material layer including the metal element and chlorine (Cl) element.

The upper material layer 127U and the side material layer 127S may be formed of a conductive material layer including the metal element, nitrogen element, and chlorine (Cl) element.

In an example embodiment, the metal-semiconductor compound layer 121 may be a TiSi layer, and the upper material layer 127U and the side material layer 127S may be a Ti layer, but embodiments are not limited thereto, and other materials may be substituted. For example, the TiSi layer of the metal-semiconductor compound layer 121 may be replaced with a material layer, such as TiGe layer, TiSiGe layer, TiSiN layer, TiGeN layer, TiSiGeN layer, CoSi layer, CoGe layer, CoSiGe layer, CoSiN layer, CoGeN layer, CoSiGeN layer, NiSi layer, NiGe layer, NiSiGe layer, NiSiN layer, NiGeN layer, NiSiGeN layer, TaSi layer, TaGe layer, TaSiGe layer, TaSiN layer, TaGeN layer, TaSiGeN layer, WSi layer, WGe layer, WSiGe layer, WSiN layer, WGeN layer, or WSiGeN layer, or the like. The upper material layer 127U and the side material layer 127S may be replaced with a material layer such as the Ti layer, a Ta layer, Co layer, Ni layer, W layer, TiN layer, TaN layer, CoN layer, NiN layer, or WN layer, or the like.

The upper material layer 127U and the side material layer 127S may further include Cl element as an impurity.

The metal-semiconductor compound layer 121 may include a lower region 121L and an upper region 121U on the lower region 121L. When the metal-semiconductor compound layer 121 is formed of an MSix material layer, M may be a metal element such as Ti, Co, Ni, Ta or W, and the concentration of the Si element in the lower region 121L may be higher than the concentration of the Si element in the upper region 121U. In this case, the Si element may be replaced with Ge or SiGe.

The metal-semiconductor compound layer 121 may be formed by reacting a portion of the first region 112 with a metal element at a formation temperature of the metal-semiconductor compound. Therefore, in the metal-semiconductor compound layer 121, the lower region 121L is formed at a level lower than the upper surface of the peripheral area 115, and the upper region 121U may be formed to extend into the contact hole 118a.

In the metal-semiconductor compound layer 121, the concentration of the semiconductor element in the lower region 121L may be higher than the concentration of the semiconductor element in the upper region 121U. In this case, the semiconductor element may be at least one of Si or Ge.

When the metal-semiconductor compound layer 121 is formed of a material layer such as TiSiN, the concentration of the N element in the upper region 121U may be higher than the concentration of the N element in the lower region 121L. In this case, Ti may be replaced with other metal elements, and Si may be replaced with Ge or SiGe.

When the metal-semiconductor compound layer 121 is formed of a material layer such as TiSiN, the concentration of Si element in the lower region 121L may be higher than that of N element, in the upper region 121U, the concentration of the N element may be higher than the concentration of the Si element.

The metal-semiconductor compound layer 121 may have a thickness ranging from about 1.5 nm to about 12 nm. In some embodiments, the metal-semiconductor compound layer 121 may have a thickness ranging from about 2 nm to about 7 nm.

After the third process (S50), the material layer having a required thickness may be the metal-semiconductor compound layer 121 within a thickness range of about 1.5 nm to about 12 nm.

After the third process (S50), the material layer having a required thickness may be the metal-semiconductor compound layer 121 within a thickness range of about 2 nm to about 7 nm.

The fourth process (S60) may be a process of removing at least a portion of the side material layer 127S. Accordingly, the fourth process may be referred to as a removal process. The side material layer 127S prior to the removal of a portion of the side material layer 127S may be referred to as a preliminary sidewall material layer.

In an example, after the fourth process (S60) is performed, the side material layer 127S may be completely removed.

In another example, after the fourth process (S60) is performed, the thickness of the remaining side material layer 127S is about 1 nm or less.

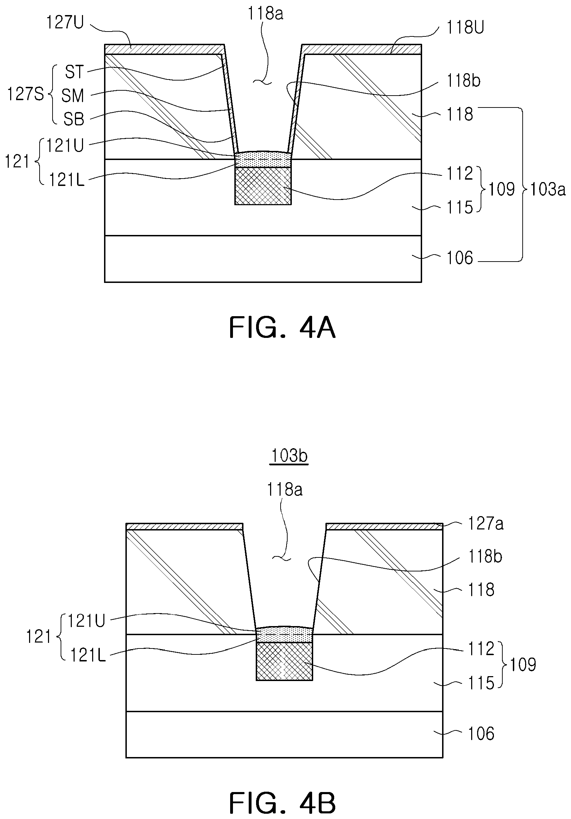

As illustrated in FIG. 4A, the fourth process is performed (S60) on the side material layer 127S and the upper material layer 127U, and the thickness of the upper material layer 127U may be reduced while removing the side material layer 127S. After the fourth process (S60), the upper material layer 127U remaining on the upper surface 118U of the second structure 118 may have a reduced thickness as illustrated in FIG. 4B and form an upper material layer 127a having a reduced thickness. The upper material layer 127U prior to the performance of the fourth process may be referred to as a preliminary upper material layer.

Thus, a substrate 103b including the metal-semiconductor compound layer 121 and the upper material layer 127a may be formed.

The substrate 103b on which the second semiconductor process has been performed may be unloaded from the process chamber 3 (S70).

According to the above-described embodiment, forming the metal-semiconductor compound layer 121 may include performing a first process of exposing the substrate 103a to the process gases PG in a state in which the plasma power is turned off (S40); repeatedly performing two or more times, a second process (S45) of repeatedly performing a plasma process performed for a first time while the plasma power is turned on and a process of exposing the substrate 103a to the process gases PG for a second time while the plasma power is turned off, and a third process (S50) of exposing the substrate 103a to the process gases PG while turning off the plasma power, after the first process (S40); and performing a fourth process (S60) of exposing the substrate 103a to the process gases PG in a state in which the plasma power is turned off after repeating the second and third processes (S45 and S50) two or more times.

Referring to FIGS. 1, 2A, and 5A, a third semiconductor process may be performed on the unloaded substrate (103b in FIG. 4B) (S80).

Performing the third semiconductor process (S80) may include forming at least one conductive material layer on the unloaded substrate (103b in FIG. 4B), and patterning the at least one conductive material layer to form a conductive structure (139). The at least one conductive material layer may be patterned to form the conductive pattern 130 (e.g., portions of the conductive material other than the conductive pattern 130 may be removed). The upper material layer 127a may remain between the conductive pattern 130 and the upper surface 118U of the second structure 118. Accordingly, a conductive structure 139 including the metal-semiconductor compound layer 121, an upper material layer 127a, and the conductive pattern 130 may be formed.

The conductive pattern 130 may include a first material layer 133 and a second material layer 136 on the first material layer 133. The first material layer 133 may be formed of and/or include a metal-nitride such as TiN, TaN, or WN, and the second material layer 136 may be formed of and/or include a metal such as W or Mo.

The first material layer 133 may be formed in a liner shape. The first material layer 133 may contact the metal-semiconductor compound layer 121, side surfaces 118b of the contact hole 118a and the upper material layer 127a. The second material layer 136 may contact the first material layer 133 and a portion of the second material layer 136 may be formed in the contact hole 118a.

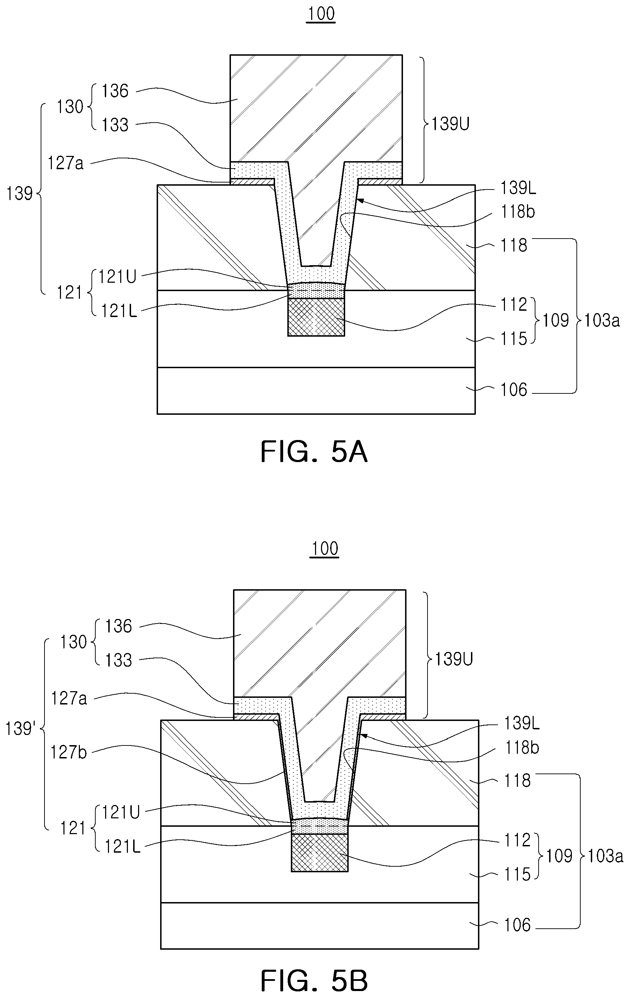

According to an example embodiment, a semiconductor device 100 manufactured by the above-described method may be provided. The semiconductor device 100 as described above may include the semiconductor substrate 106 as described above, the first structure 109 on the semiconductor substrate 106, the second structure 118 on the first structure 109, and the conductive structure 139. The first structure 109 may include the first region 112 and a peripheral area 115 around the first region 112. The first region 112 may be a conductive region formed by doping an impurity into a semiconductor material. The conductivity type of the conductive region may be determined by the type of impurity doped into the semiconductor material. The second structure 118 may have a contact hole 118a exposing at least a portion of the first region 112. The second structure 118 may be an insulating structure formed of and/or including an insulating material such as silicon oxide or silicon nitride. An inclined side surface 118b of the contact hole 118a may have a positive slope. The conductive structure 139 may include the metal-semiconductor compound layer 121, the upper material layer 127a, and the conductive pattern 130 as described above with reference to FIG. 5A. The thickness of the first material layer 133 of the conductive pattern 130 may be substantially the same as the thickness of the metal-semiconductor compound layer 121. The thickness of the first material layer 133 may be greater than that of the upper material layer 127a.

In the above-described embodiment, after the fourth process (S60), the side material layer 127S may be completely removed, and the conductive pattern 130 may contact the sidewall of the contact hole 118a.

In another example, after the fourth process (S60), the side material layer (127S in FIG. 4A) may remain. In this manner, an example in which the side material layer (127S in FIG. 4A) remains will be described with reference to FIG. 5B. FIG. 5B is a schematic cross-sectional view of an illustrative example in which the side material layer (127S in FIG. 4A) remains after the fourth process (S60).

Referring to FIG. 5B, after the fourth process (S60), the side material layer (127S of FIG. 4A) may be formed as a side material layer (127b of FIG. 5B) having a reduced thickness. The thickness of the remaining side material layer 127b may be about 1 nm or less. Accordingly, the side material layer 127b may remain between the conductive pattern 130 and the side surface of the contact hole 118a. Accordingly, the conductive structure 139' of FIG. 5B may be the similar to the conductive structure 139 of FIG. 5A with the exception that the conductive structure 139' of FIG. 5B further includes the side material layer 127b as illustrated in FIG. 5B.

According to example embodiments, the side material layer 127S in FIG. 4A is completely removed to provide a conductive structure 139 as in FIG. 5A, or the side material layer 127S in FIG. 4A is partially removed to form the remaining side material layer 127b with a thickness of about 1 nm or less, as in FIG. 5B, to provide the conductive structure 139' as in FIG. 5B. According to these embodiments, the conductive structure (139 in FIG. 5A and 139 ' in FIG. 5B) may be formed without defects such as voids in the contact hole 118a. Accordingly, the resistance characteristics of the conductive structure (139 in FIG. 5A and 139' in FIG. 5B) may be improved.

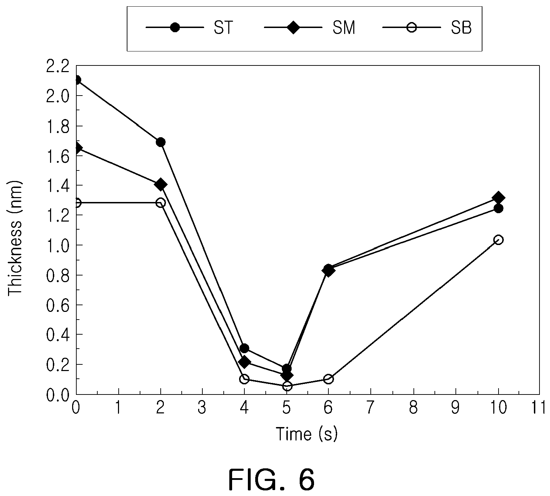

Next, with reference to FIG. 6, the thickness of the side material layer (127S in FIG. 4A) described in FIG. 4A according to the duration the third process is performed (S50) will be described. FIG. 6 is a graph illustrating the remaining thickness of the side material layer 127S described in FIG. 4A (e.g., the thickness of the side material layer 127b) according to the duration the third process is performed (S50), and in this graph, the horizontal axis represents the duration (e.g., an amount of time elapsed since the process began) of the third process (S50), and the vertical axis represents the remaining thickness of the side material layer 127S described in FIG. 4A. In the graph of FIG. 6, ST represents the remaining thickness of the upper region ST of the side material layer 127S in FIG. 4A, SM represents the remaining thickness of the middle region SM of the side material layer 127S in FIG. 4A, and SB represents the remaining thickness of the lower region SB of the side material layer 127S in FIG. 4A.

Referring to FIGS. 4A and 6, when the duration of the third process (S50) is about 2 seconds, the thickness of the lower region SB is about 1.3 nm, and the thickness of the middle region SM is about 1.4 nm, and the thickness of the upper region ST is about 1.7 nm. When the duration of the third process (S50) is about 4 seconds, the thickness of the lower region SB is about 0.1 nm, and the thickness of the middle region SM is about 0.2 nm, and the thickness of the upper region ST is about 0.3 nm. From the graph results, it can be seen that the thickness of the side material layer 127S starts to decrease rapidly after about 2 seconds of duration of the third process (S50).

As the thickness of the side material layer 127S decreases, the volume of the conductive pattern 130 disposed within the contact hole 118a may increase. Accordingly, since the conductive pattern 130 may include a material such as tungsten having an electrical resistance lower than that of the material of the side material layer 127S, electrical characteristics of the conductive structure 139 may be improved as the thickness of the side material layer 127b is reduced.

As the thickness of the side material layer 127b is reduced, the conductive pattern 130 may be formed in the contact hole 118a without or with reduced defects such as voids. Accordingly, since the conductive pattern 130 may be formed without or with less defects such as voids, the resistance characteristics of the conductive structure 139 may be improved as the thickness of the side material layer 127b is reduced.

In some embodiments, to provide the conductive structure 139 with improved resistance characteristics, the third process time for performing the third process (S50) may be in the range of about 2 seconds to about 6 seconds.

In some embodiments, to provide the conductive structure 139 with improved resistance characteristics, the third process time for performing the third process (S50) may be in the range of about 3 seconds to about 5.5 seconds.

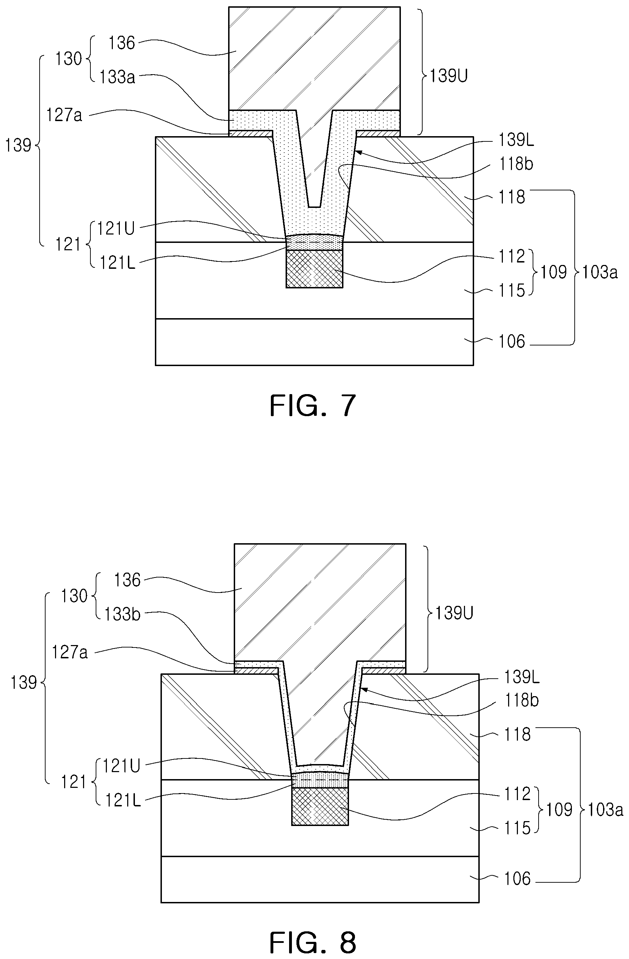

Hereinafter, with reference to FIGS. 7, 8, 9, and 10, various embodiments that may be modifications of the semiconductor device described previously which was formed by performing the third semiconductor process (S80) on the unloaded substrate (103b in FIG. 4B) will be described. Because some components may be substantially the same as those described previously, they may be described briefly, or their description may be omitted. Various modified examples of the components of the above-described embodiment will be described below focusing on the modified or replaced components. In addition, components that may be modified or replaced as described below are described with reference to the following drawings, but the components that may be modified or replaced may be combined with each other. Alternatively, in some embodiments a semiconductor device may be configured in combination with the components described above. FIGS. 7, 8, 9, and 10 are cross-sectional views schematically illustrating various modified examples of the semiconductor device 100 described in FIG. 5A.

In a modified example, referring to FIG. 7, a first material layer 133a may be similar to the first material layer 133 of FIGS. 5A and 5B, but may have a thickness greater than that of the metal-semiconductor compound layer 121. The thickness of the first material layer 133a may be twice or more than the thickness of the upper material layer 127a.

In a modified example, referring to FIG. 8, a first material layer 133b may be similar to the first material layer 133 of FIGS. 5A and 5B, but may have a thickness smaller (e.g., less than) than that of the metal-semiconductor compound layer 121.

In an example, the thickness of the first material layer 133b may be greater than the thickness of the upper material layer 127a.

In another example, the thickness of the first material layer 133b may be the same as that of the upper material layer 127a.

In another example, the thickness of the first material layer 133b may be smaller (e.g., less than) than the thickness of the upper material layer 127a.

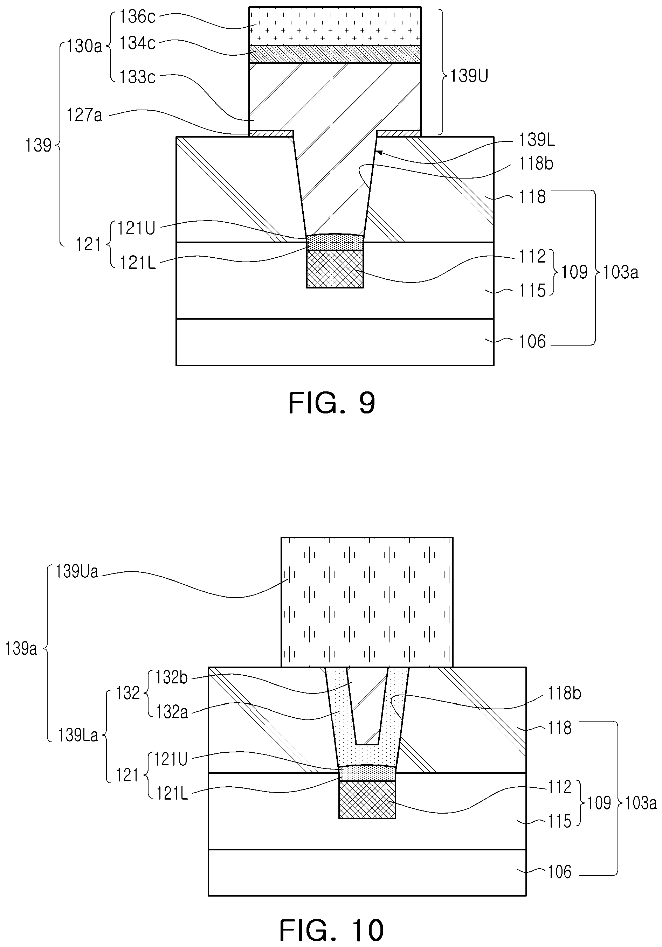

In a modified example, referring to FIG. 9, a conductive pattern 130a may be similar to the conductive pattern 130 of FIGS. 5A and 5B, but a lower material layer 133c may contact the metal-semiconductor compound layer 121, fill the contact hole 118a, and cover the upper material layer 127a.

The conductive pattern 130a may further include an intermediate material layer 134c on the lower material layer 133c and an upper material layer 136c on the intermediate material layer 134c. The intermediate material layer 134c may be disposed between the lower material layer 133c and the upper material layer 136c.

An upper surface of the lower material layer 133c may be disposed at a higher level than an upper surface of the second structure 118. Accordingly, the intermediate material layer 134c and the upper material layer 136c may be disposed at a level higher than the upper surface of the second structure 118.

The lower material layer 133c may be formed of and/or include a metal nitride such as TiN, TaN, or WN. The intermediate material layer 134c may be formed of and/or include a conductive material such as TiSiN, TaSiN, or WSiN. The upper material layer 136c may be formed of and/or include a metal material such as W.

In a modified example, referring to FIG. 10, a conductive structure 139a includes a lower region 139La disposed in the contact hole 118a and having an upper surface coplanar with an upper surface of the second structure 118 and an upper region 139Ua on the lower region 139La.

The lower region 139La may be formed of and/or include the same metal-semiconductor compound layer 121 as described in FIGS. 5A and 5B and a plug portion 132 on the metal-semiconductor compound layer 121. The plug portion 132 may include a first material layer 132a contacting the metal-semiconductor compound layer 121 and covering a side surface 118b of the contact hole 118a, and a second material layer 132b filling the contact hole 118a on the first material layer 132a. The first material layer 132a may be a barrier layer formed of and/or including a material such as TiN, and the second material layer 132b may be a metal layer formed of and/or including a material such as W.

The upper region 139Ua may contact the upper surface of the lower region 139La and the upper surface of the second structure 118. The upper region 139Ua may include at least one conductive material layer.

In FIGS. 7, 8, 9, and 10, embodiments having modified examples of some components of the conductive structure 139 of FIG. 5A are described, and the conductive structures 139 and 139a of FIGS. 7, 8, 9, and 10 may be modified to further include the side material layer (127b of FIG. 5B) as in FIG. 5B.

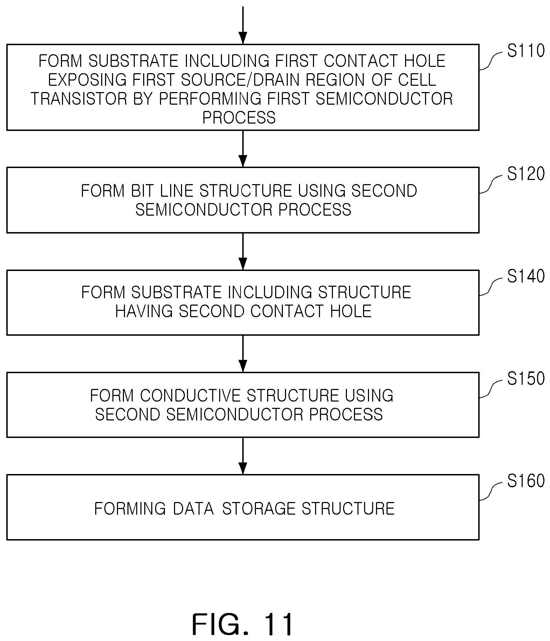

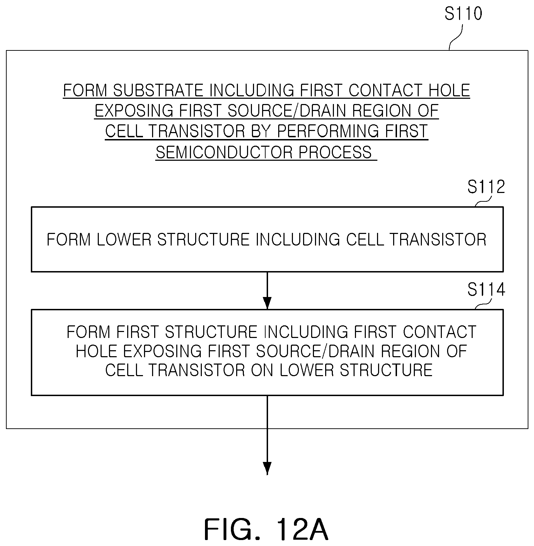

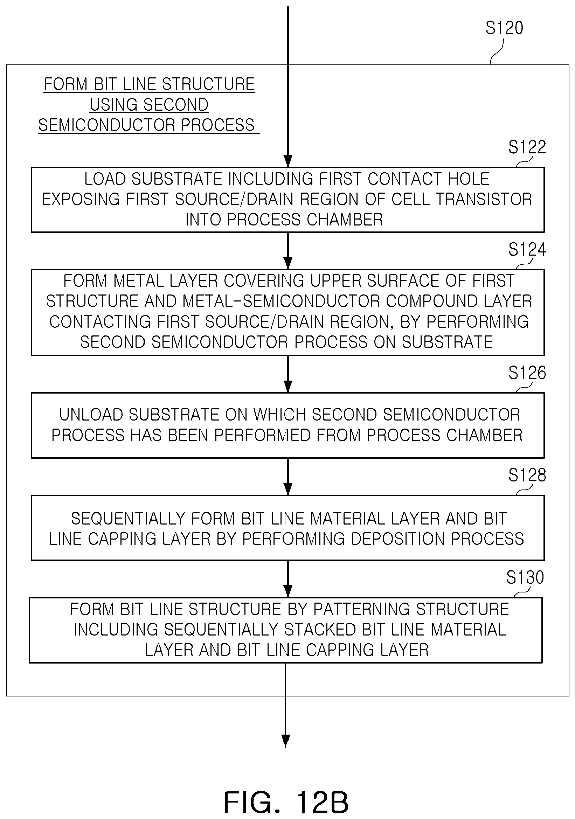

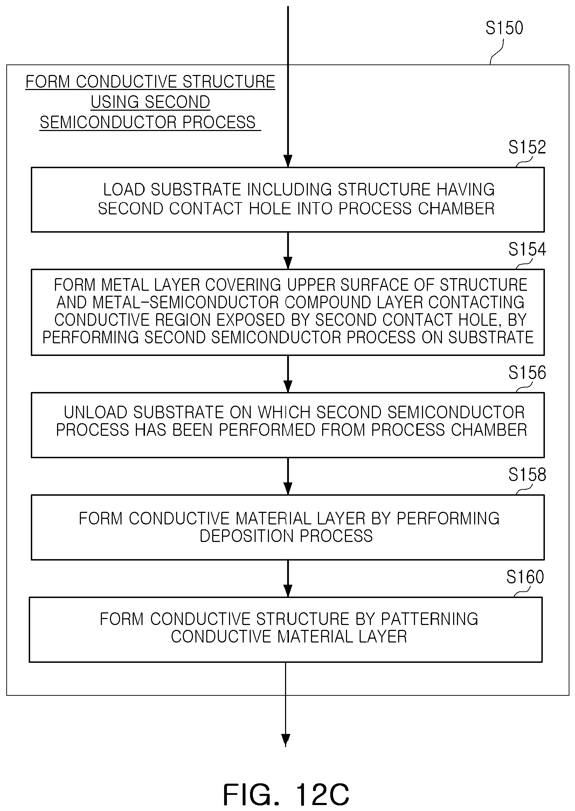

Hereinafter, with reference to FIGS. 11 to 17, an illustrative example of a method of manufacturing a semiconductor device using the method described above with reference to FIGS. 1 to 5A and an illustrative example of a semiconductor device manufactured using the method of manufacturing a semiconductor device will be described. In the illustrative example described below, the side material layer (127b in FIG. 5B) as in FIG. 5B is not illustrated, but in the following embodiments, the side material layer (127b of FIG. 5B) as illustrated in FIG. 5B may remain on at least two groups of side surfaces of the contact hole.

In FIGS. 11 to 17, FIGS. 11, 12A, 12B, and 12C are process flow charts providing illustrative examples of a method of manufacturing a semiconductor device using the method described above with reference to FIGS. 1 to 5A, and FIGS. 13 to 17 are diagrams illustrating examples of semiconductor devices manufactured by the method of manufacturing the semiconductor device of FIGS. 11 to 12C.

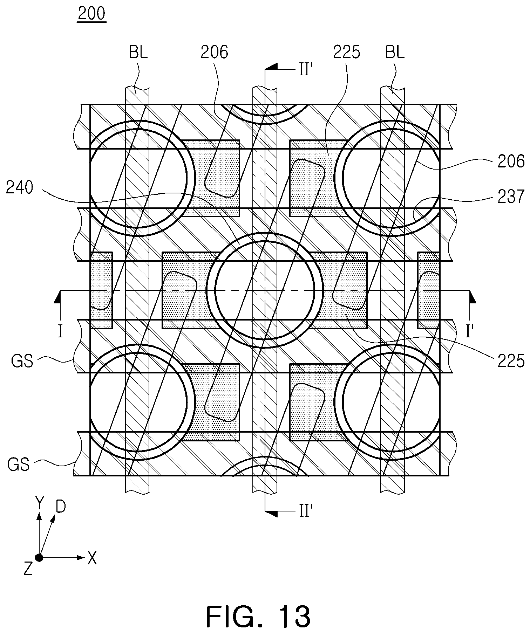

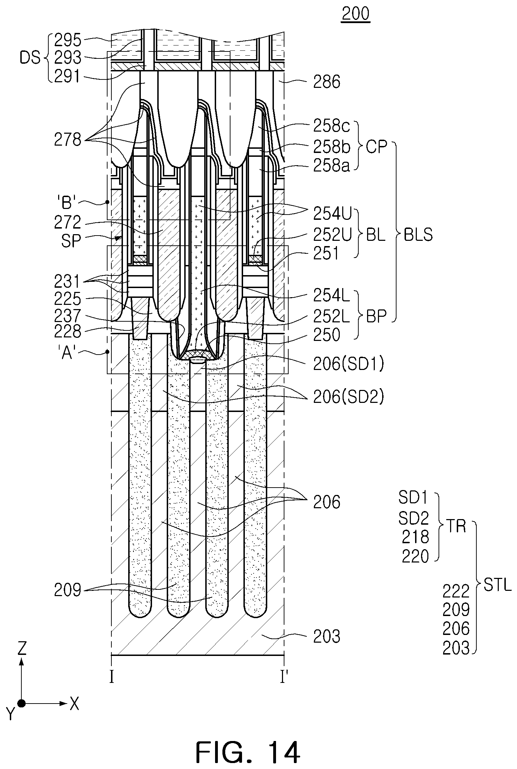

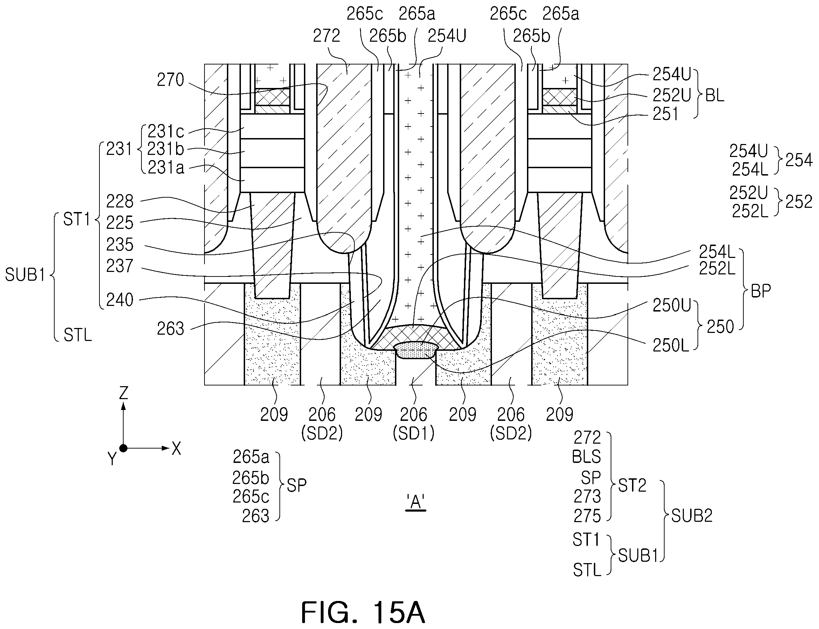

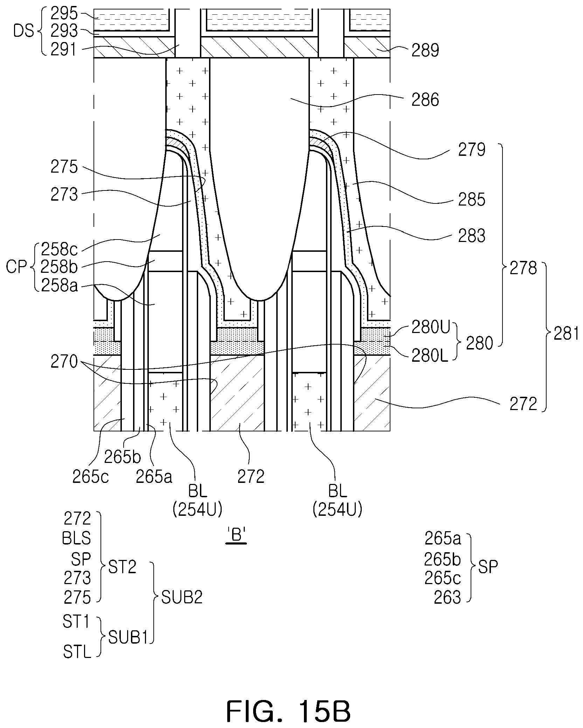

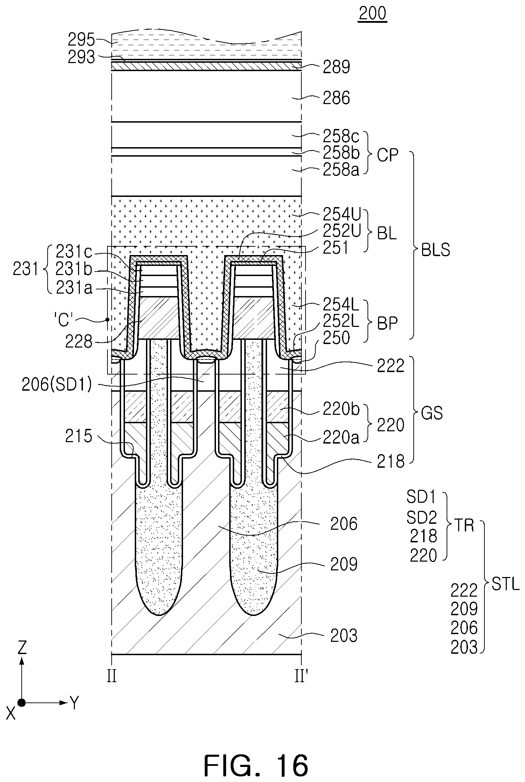

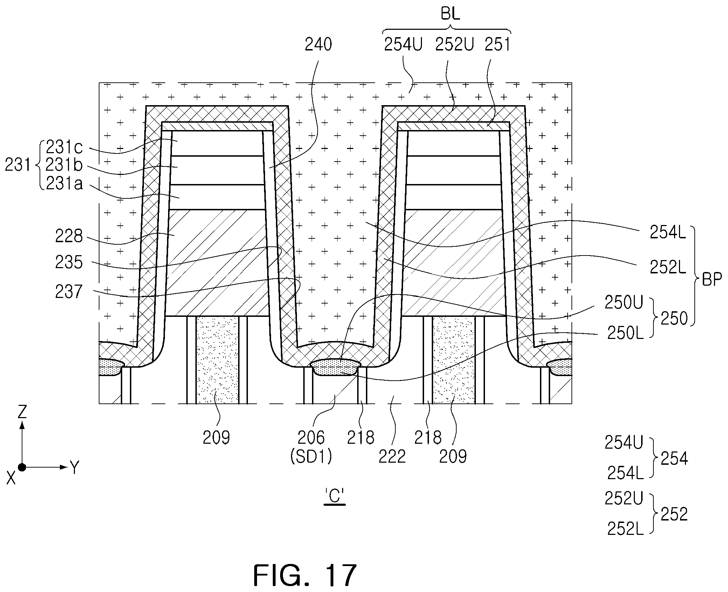

In FIGS. 13 to 17, FIG. 13 is a top view conceptually illustrating a semiconductor device manufactured using a method of manufacturing a semiconductor device according to an example embodiment, FIG. 14 is a cross-sectional view conceptually illustrating a region taken along line I-I' of FIG. 13, FIG. 15A is a partially enlarged view of the area marked 'A' in FIG. 14, FIG. 15B is a partially enlarged view of the area marked 'B' in FIG. 14, FIG. 16 is a cross-sectional view conceptually illustrating a region taken along line II-II' of FIG. 13, and FIG. 17 is a partial enlarged view of the area indicated by 'C' in FIG. 16.

Referring to FIGS. 11 to 12C and 13 to 17, a first semiconductor process is performed, and a substrate SUB1 including a first contact hole exposing a first source/drain region of a cell transistor may be formed (S110 in FIG. 11).

The substrate SUB1 may include a lower structure STL and a first structure ST1 on the lower structure STL.

The lower structure (STL) may include a semiconductor substrate 203, active regions 206 on the semiconductor substrate 203, and an isolation region 209 covering side surfaces of the active regions 206 on the semiconductor substrate 203.

The semiconductor substrate 203 may be formed of and/or include a Group IV semiconductor, a Group III-V compound semiconductor, or a Group II-VI compound semiconductor. For example, the group IV semiconductor may include silicon, germanium, or silicon-germanium. For example, the semiconductor substrate 203 may be formed of and/or include a silicon material, for example, a single crystal silicon material. The semiconductor substrate 203 may be a silicon substrate, a silicon on insulator (SOI) substrate, a germanium substrate, a germanium on insulator (GOI) substrate, a silicon-germanium substrate, or a substrate including an epitaxial layer.

The isolation region 209 may define the active regions 206 on the semiconductor substrate 203. The isolation region 209 may be a trench device isolation layer. The isolation region 209 may be formed of and/or include an insulating material such as silicon oxide and/or silicon nitride.

Each of the active regions 206 may have a fin shape protruding from the semiconductor substrate 203 in a vertical direction (Z). The active regions 206 may be formed of the same material as the semiconductor substrate 203, for example, silicon. For example, the active regions 206 may include single crystal silicon. The vertical direction Z may be a direction perpendicular to the upper surface of the substrate 203. The active regions 206 may be parallel to each other.

The lower structure (STL) may further include gate trenches 215 crossing the active regions 206 and extending into the isolation region 209, gate structures GS in the gate trenches 215, and first and second source/drain regions SD1 and SD2 disposed in upper regions of the active regions 206 and spaced apart from each other by the gate structures GS (e.g., on opposing sides (both sides) of the gate structure). The gate structures GS may be parallel to each other.

In a top view, each of the gate structures GS may have a line shape extending in the first horizontal direction X. In a top view, each of the active regions 206 may have a bar shape or a line shape extending in an oblique direction D. The oblique direction D may be a direction crossing the first horizontal direction X while forming an obtuse angle or an acute angle with the first horizontal direction X.

Each of the gate structures GS may include a gate dielectric layer 218 covering an inner wall of the gate trench 215, a gate electrode 220 partially filling the gate trench 215 on the gate dielectric layer 218, and a gate capping pattern 222 filling the remaining portion of the gate trench 215 on the gate electrode 220.

The gate dielectric layer 218 may be formed of and/or include at least one of silicon oxide and a high-k dielectric. The high-k dielectric may be a dielectric having a higher dielectric constant than that of silicon oxide. The gate electrode 220 may be formed of and/or include doped polysilicon, metal, conductive metal nitride, metal-semiconductor compound, conductive metal oxide, graphene, carbon nanotube, or combinations thereof. For example, the gate electrode 220 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, graphene, carbon nanotube, or combinations thereof, but is not limited thereto. The gate electrode 220 may include a single layer or multiple layers of the above materials. For example, the gate electrode 220 may include a first electrode layer 220a that may be formed of and/or include a metal material and a second electrode layer 220b that may be formed of and/or include doped polysilicon on the first electrode layer 220a. The gate capping pattern 222 may be formed of and/or include an insulating material, for example, silicon nitride.

The first and second source/drain regions SD1 and SD2 may be impurity regions having N-type conductivity. The first and second source/drain regions SD1 and SD2 may be formed of and/or include doped Si, doped SiGe, or doped Ge.

The first and second source/drain regions SD1 and SD2, the gate electrode 220 and the gate dielectric layer 218 may constitute a cell transistor TR. The cell transistor TR may be a cell transistor in a memory such as a DRAM.

The first source/drain regions SD1 and the second source/drain regions SD2 may be disposed in the active regions 206. The first and second source/drain regions SD1 and SD2 may be disposed in upper regions of the active regions 206.

In example embodiments, the first and second source/drain regions SD1 and SD2 may be described as being referred to as upper regions of the active regions 206.

One active region 206 of the active regions 206 may cross a pair of adjacent gate structures GS among the gate structures GS. In the top view, when viewed based on one active area of the active areas 206, one first source/drain region SD1 is disposed in the middle of the active region 206, and the second source/drain regions SD2 may be disposed at both ends of the active region 206. The first and second source/drain regions SD1 and SD2 may be adjacent to the gate capping patterns 222.

The first structure ST1 may include pad patterns 225, an insulating isolation pattern 228, and an insulating buffer pattern 231 on the pad patterns 225 and the insulating isolation pattern 228.

The pad patterns 225 may be spaced apart from each other. The pad patterns 225 may be respectively connected to the second source/drain regions SD2 spaced apart from each other on the second source/drain regions SD2. For example, one pad pattern 225 may contact and be electrically connected to one second source/drain region SD2. One of the pad patterns 225 may contact the upper surface of the electrically connected second source/drain region SD2 and cover a portion of the upper surface of the isolation region 209 adjacent to the second source/drain region SD2.

Each of the pad patterns 225 may include at least one conductive layer. Each of the pad patterns 225 may be formed of and/or include doped silicon, metal, conductive metal nitride, metal-semiconductor compound, conductive metal oxide, graphene, carbon nanotube, or combinations thereof. For example, each of the pad patterns 225 may be formed of and/or include doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, graphene, carbon nanotube, or combinations thereof, but is not limited thereto. Each of the pad patterns 225 may include a single layer or multiple layers of the aforementioned materials.

The insulating isolation pattern 228 may be formed of and/or include an insulating material such as silicon nitride or silicon oxide. Side surfaces of the insulating isolation pattern 228 and the pad patterns 225 may contact each other. For example, side surfaces of the insulating isolation pattern 228 may contact side surfaces of the pad patterns 225. Upper surfaces of the insulating isolation pattern 228 may be coplanar with upper surfaces of the pad patterns 225. An upper surface of the insulating isolation pattern 228 may be disposed at substantially the same level as upper surfaces of the pad patterns 225. A lower surface of the insulating isolation pattern 228 may be disposed at a lower level than lower surfaces of the pad patterns 225. The insulating isolation pattern 228 may pass between the pad patterns 225 and extend into the isolation region 209. The insulating isolation pattern 228 may cover a portion of the gate structure GS adjacent to the isolation region 209. For example, the insulating isolation pattern 228 may cover an upper surface of a portion of the gate capping pattern 222 and an upper portion of a portion of the gate dielectric layer 218.

The insulating buffer pattern 231 may include at least one insulating layer. For example, the insulating buffer pattern 231 may include a first buffer layer 231a, a second buffer layer 231b, and a third buffer layer 231c sequentially stacked. The first buffer layer 231a may be formed of and/or include silicon nitride, the second buffer layer 231b may be formed of and/or include silicon oxide, and the third buffer layer 231c may be formed of and/or include silicon nitride.

The first structure ST1 may further include preliminary contact holes 235 penetrating the pad pattern 225 and the insulating isolation pattern 228 and exposing the first source/drain regions SD1, spacers 240 covering sidewalls of the preliminary contact holes 235, and first contact holes 237 defined by the spacer 240 and exposing the first source/drain regions SD1.

Heights of upper surfaces of the first source/drain regions SD1, the isolation region 209, and the gate capping pattern 222 exposed by the preliminary contact holes 235 by the process of forming the preliminary contact holes 235 may be lowered.

A plurality of preliminary contact holes 235 may be disposed to expose each of the first source/drain regions SD1. Hereinafter, for easier understanding, one preliminary contact hole 235 and one first source/drain region SD1 will be mainly described. However, the description may be applicable to other contact holes 235 and source/drain regions SD1.

Therefore, the operation (S110) of forming the substrate SUB1 including the first contact hole 237 exposing the first source/drain region SD1 of the cell transistor TR by proceeding with the first semiconductor process may include forming the lower structure STL including the cell transistor TR (S112), and forming the first structure ST1 including the first contact hole 237 exposing the first source/drain region SD1 of the cell transistor TR on the lower structure STL (S114).

Bit line structures BLS may be formed using a second semiconductor process (S120). The second semiconductor process may be the second semiconductor process described with reference to FIGS. 1 to 5A. For example, the operation (S120) of forming the bit line structures BLS by using the second semiconductor process may include loading the substrate SUB1 including the first contact hole 237 exposing the first source/drain region SD1 of the cell transistor TR into the process chamber (3 in FIG. 1) (S122), forming a material layer 251 covering the upper surface of the first structure ST1 and the metal-semiconductor compound layer 250 contacting the first source/drain region SD1 by performing the second semiconductor process on the substrate SUB1 (S124), unloading the substrate on which the second semiconductor process has been performed from the process chamber (3 in FIG. 1) (S126), performing a deposition process to sequentially form a bit line material layer and a bit line capping layer (S128), and forming bit line structures BLS by patterning a structure including the sequentially stacked bit line material layer and bit line capping layer (S130).

The second semiconductor process is performed on the substrate SUB1 to cover the upper surfaces of the first source/drain region SD1 and the first structure ST1. Forming the material layer 251 and the metal-semiconductor compound layer 250 (S124) may be substantially the same as performing the second semiconductor process on the substrate in FIG. 2B (S30). Accordingly, the metal-semiconductor compound layer 250 may be formed of substantially the same material as the metal-semiconductor compound layer (121 of FIG. 5A) in FIG. 5A, and the material layer 251 may be formed of substantially the same material as the upper material layer 127a in FIG. 5A.

The metal-semiconductor compound layer 250 may include a lower region 250L and an upper region 250U on the lower region 250L. In the metal-semiconductor compound layer 250, the lower region 250L may be formed of the same material as the lower region (121L in FIG. 5A) described above, and the upper region 250U may be formed of the same material as the above-described upper region (121U in FIG. 5A).

The thickness of the metal-semiconductor compound layer 250 may be substantially the same as the thickness of the metal-semiconductor compound layer (121 in FIG. 5A) in FIG. 5A, and the thickness of the material layer 251 may be substantially the same as the thickness of the upper material layer (127a of FIG. 5A) in FIG. 5A.

Each of the bit line structures BLS may include a plug portion BP, a bit line BL, and a bit line capping pattern CP.

The plug portion BP is formed in the first contact hole 237 and may contact and electrically be connected to the first source/drain region SD1. The bit line BL is formed on the plug portion BP and extends in the second horizontal direction Y, and may be formed on an upper surface of the first structure ST1. The second horizontal direction Y may be perpendicular to the first horizontal direction X.

The plug portion BP may partially fill the first contact hole 237 in the first horizontal direction X, and the plug portion BP may partially fill the first contact hole 237 in the second horizontal direction Y. Thus, the first contact hole 237 may be filled.

At least a portion of the cross-sectional structure of the conductive structure including the plug portion BP and the bit line BL cut along the second horizontal direction Y may be similar to the cross-sectional structure of the conductive structures 139 and 139a of any one of the embodiments of FIGS. 5A, 5B, 7, 8, 9, and 10. For example, as illustrated in FIGS. 16 and 17, at least a portion of cross-sectional structures of the plug portion BP and the bit line BL cut along the second horizontal direction Y may be similar to the conductive structure (139 of FIG. 5A) described in FIG. 5A. For example, the cross-sectional structure of the conductive structure including the plug portion BP and the bit line BL cut along the second horizontal direction Y may include the metal-semiconductor compound layer 250 in contact with the first source/drain region SD1, a liner-shaped first material layer 252 covering the metal-semiconductor compound layer 250, a second material layer 254 on the first material layer 252, and the first material layer 252 and the material layer 251 covering upper surfaces of the first structure ST1. A portion of the second material layer 254 may be formed in the first contact hole 237.

The first material layer 252 may be formed of the same material as the first material layer (133 of FIG. 5A) described with reference to FIG. 5A, and the second material layer 254 may be formed of the same material as the second material layer (136 in FIG. 5A) described with reference to FIG. 5A.

The first material layer 252 may include a first lower portion 252L positioned within the first contact hole 237 and a first upper portion 252U positioned at a level higher than the first contact hole 237. The second material layer 254 may include a second lower portion 254L positioned within the first contact hole 237 and a second upper portion 254U positioned at a higher level than the first contact hole 237. Accordingly, the plug portion BP may include the metal-semiconductor compound layer 250, the first lower portion 252L and the second lower portion 254L, and the bit line BL may include the material layer 251, the first upper portion 252U, and the second upper portion 254U.

In the cross-sectional structure of the conductive structure including the plug portion BP and the bit line BL cut along the second horizontal direction Y as illustrated in FIGS. 16 and 17, the first material layer 252 is formed in a liner shape under the second material layer 254 and may cover the metal-semiconductor compound layer 250. In addition, the first material layer 252 may contact the gate capping pattern (222).

In the second horizontal direction Y, the width of the plug portion BP may be greater than that of the first source/drain region SD1.

In the cross-sectional structure of the plug portion BP cut along the first horizontal direction X as illustrated in FIGS. 14 and 15A, the first lower portion 252L may be disposed below a lower surface of the second lower portion 254L and may not cover a side surface of the second lower portion 254L, and may contact the isolation region 209 adjacent to the first source/drain region SD1.

The bit line BL may include the material layer 251, the first upper portion 252U, and the second upper portion 254U sequentially stacked on the upper surface of the first structure ST1.

The bit line capping pattern CP may be formed on the bit line BL. The bit line capping pattern CP may be formed of an insulating material such as silicon nitride. The bit line capping pattern CP may include at least one material layer. For example, the bit line capping pattern CP may include a first capping layer 258a, a second capping layer 258b, and a third capping layer 258c sequentially stacked.

Spacer structures SP may be formed on side surfaces of the bit line structures BLS. The spacer structure SP may include a first spacer 265a, a second spacer 265b, a third spacer 265c, and a lower spacer 263.

The first spacer 265a may cover side surfaces of the bit line structures BLS and may extend to cover an inner wall of the first contact hole 237 not filled by the plug portion BP. The second spacer 265b may cover the first spacer 265a on a side surface of the bit line BL. The third spacer 265c may cover the second spacer 265b on a side surface of the bit line BL. The second spacer 265b may be disposed between the first and third spacers 265a and 265c. An upper end of the first spacer 265a may be disposed at a higher level than upper ends of the second and third spacers 265b and 265c. Upper ends of the second and third spacers 265b and 265c may be disposed at a level higher than that of the bit line BL.

A portion of the third spacer 265c may extend into the first contact hole 237. The lower spacer 263 may fill a portion of the first contact hole 237 not filled by the plug portion BP on the first spacer 265a.

The first spacer 265a may be formed of and/or include at least one of SiN, SiCN, SiON, and SiOCN. The second spacer 265b may be an air gap. It should be appreciated that an "air gap" may comprise a gap having air or other gases (e.g., such as those present during manufacturing) or may comprise a gap forming a vacuum therein. The third spacer 265c may be formed of and/or include at least one of SiN, SiCN, SiON, and SiOCN. The lower spacer 263 may be formed of and/or include at least one of SiN and SiCN.

A contact hole 270 may be formed between the bit line structures BLS. The contact hole 270 may expose at least a portion of the pad pattern 225.

A lower contact plug 272 may be formed that partially fills the contact hole 270 and has an upper surface positioned at a level lower than upper ends of the second and third spacers 265b and 265c. The lower contact plug 272 may be formed of and/or include doped polysilicon. For example, the lower contact plug 272 may be formed of and/or include polysilicon having an N-type conductivity.

An upper spacer 273 covering a side surface of the contact hole 270 may be formed on the lower contact plug 272. The upper spacer 273 may be formed of an insulating material such as silicon nitride or silicon oxide. A second contact hole 275 may be defined by the upper spacer 273 in an upper region of the contact hole 270.

Accordingly, the structure ST2 including the bit line structure BLS, the spacer structure SP, the lower contact plug 272, the upper spacer 273, and the second contact hole 275 may be formed. In this case, the structure ST2 may also be referred to as a second structure. The lower contact plug 272 exposed by the second contact hole 275 may be referred to as a conductive region or a conductive region doped with impurities.

The first substrate SUB1 and the second structure ST2 may form a substrate SUB2. Accordingly, the substrate SUB2 may include the second contact hole 275. The substrate SUB2 may also be referred to as a second substrate. Accordingly, the substrate SUB2 including the structure ST2 having the second contact hole 275 may be formed (S150).

A conductive structure 278 may be formed using the second semiconductor process (S150). The second semiconductor process may be the second semiconductor process described with reference to FIGS. 1 to 5A. For example, forming the conductive structure 278 (S150), using the second semiconductor process, may include loading the substrate SUB2 having the second contact hole 275 into the process chamber (3 in FIG. 1) (S152), performing the second semiconductor process on the substrate SUB2, forming a metal-semiconductor compound layer 280 contacting the lower contact plug 272 exposed by the second contact hole 275 and a material layer 279 covering an upper surface of the structure ST2 (S154), unloading the substrate SUB2 on which the second semiconductor process has been performed from the process chamber 3 (S156), forming a conductive material layer by performing a deposition process (S158), and forming the conductive structure 278 by patterning the conductive material layer (S160).

By performing the second semiconductor process on the substrate SUB2, the operation (S154) of forming a metal-semiconductor compound layer 280 contacting the lower contact plug 272 exposed by the second contact hole 275 and a material layer 279 covering an upper surface of the structure ST2 may be substantially the same as performing the second semiconductor process on the substrate in FIG. 2B (S30). Accordingly, the metal-semiconductor compound layer 280 may be formed of substantially the same material as the metal-semiconductor compound layer (121 of FIG. 5A) in FIG. 5A, and the material layer 279 may be formed of substantially the same material as the upper material layer 127a in FIG. 5A.

The metal-semiconductor compound layer 280 may include a lower region 280L and an upper region 280U on the lower region 280L. In the metal-semiconductor compound layer 280, the lower region 280L may be formed of the same material as the previously described lower region (121L in FIG. 5A), and the upper region 280U may be formed of the same material as the above-described upper region (121U in FIG. 5A).

The thickness of the metal-semiconductor compound layer 280 may be substantially the same as the thickness of the metal-semiconductor compound layer (121 in FIG. 5A) in FIG. 5A, and the thickness of the material layer 279 may be substantially the same as the thickness of the upper material layer (127a of FIG. 5A) in FIG. 5A.

The conductive structure 278 may further include a first material layer 283 and a second material layer 285. The first material layer 283 may contact the upper surface of the metal-semiconductor compound layer 280 and cover the side surface of the second contact hole 275, and may cover an upper surface of the material layer 279. The second material layer 285 may be formed on the first material layer 283. The first material layer 283 may be formed of the same material as the first material layer (133 of FIG. 5A) described with reference to FIG. 5A, and the second material layer 285 may be formed of the same material as the second material layer (136 of FIG. 5A) described with reference to FIG. 5A. The material layer 279 may overlap a portion of the bit line BL in the vertical direction Z. Accordingly, the conductive structure 278 may vertically overlap a portion of the bit line BL in the vertical direction Z.

The conductive structure 278 and the lower contact plug 272 may form a contact structure 281. In the contact structure 281, a region positioned at a higher level than the second structure ST2 may be defined as a pad region.

At least a portion of the cross-sectional structure of the conductive structure 278 may be conceptually similar to the conductive structure (139 of FIG. 8) described with reference to FIG. 8. For example, at least a portion of the second contact hole 275 may have an inclined side surface like the contact hole 118b in FIG. 8, the metal-semiconductor compound layer 280 may be substantially the same as the metal-semiconductor compound layer 121 in FIG. 8, the material layer 279 may correspond to the upper material layer 127a in FIG. 8, the first material layer 283 may correspond to the first material layer 133b in FIG. 8, and the second material layer 285 may correspond to the second material layer 136 in FIG. 8. As such, at least a portion of the cross-sectional structure of the conductive structure 278 may be conceptually similar to the conductive structure (139 of FIG. 8) described in FIG. 8, but example embodiments are not limited thereto. For example, at least a portion of the cross-sectional structure of the conductive structure 278 may be similar to a cross-sectional structure of the conductive structures 139 and 139a of any one of the embodiments of FIGS. 5A, 5B, 7, 9, and 10.

An insulating isolation pattern 286 extending downward and defining a side surface of the pad region of the contact structure 281 may be formed. The insulating isolation pattern 286 may be formed of and/or include an insulating material such as silicon nitride. A lower surface of the insulating isolation pattern 286 may be disposed at a level higher than that of the metal-semiconductor compound layer 280. The insulating isolation pattern 286 may contact the bit line capping pattern CP and the conductive structure 278. The insulating isolation pattern 286 may vertically overlap a portion of the bit line BL and a portion of the lower contact plug 272.

An etch stop layer 289 may be formed on the insulating isolation pattern 286 and the conductive structure 278. The etch stop layer 289 may be formed of and/or include an insulating material. A data storage structure DS electrically connected to the conductive structure 278 may be formed.

In an example, the data storage structure DS may be a capacitor for storing information in DRAM. For example, the data storage structure DS may be a capacitor of a DRAM including a first electrode 291 passing through the etch stop layer 289 and electrically connected to the conductive structure 278, a dielectric layer 293 covering the first electrode 291 and the etch stop layer 289, and a second electrode 295 on the dielectric layer 293. The dielectric layer 293 may be formed of and/or include a high-k dielectric, silicon oxide, silicon nitride, silicon oxynitride, or combinations thereof.

In another example, the data storage structure DS may be a structure for storing DRAM and other memory information. For example, the data storage structure DS may be a capacitor of a ferroelectric memory (FeRAM) including a dielectric layer 293 disposed between the first and second electrodes 291 and 295 and including a ferroelectric layer. For example, the dielectric layer 293 may include a ferroelectric layer capable of recording data using a polarization state.

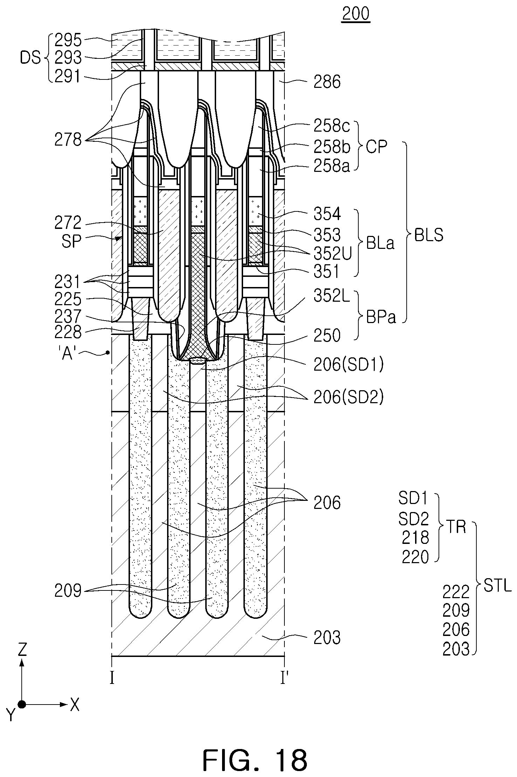

As described above with reference to FIGS. 16 and 17, at least a portion of cross-sectional structures of the plug portion BP and the bit line BL cut along the second horizontal direction Y may be similar to the conductive structure (139 of FIG. 5A) described in FIG. 5A, but the embodiment is not limited thereto. For example, at least a portion of cross-sectional structures of the plug portion BP and the bit line BL may be similar to the cross-sectional structure of the conductive structures 139', 139, and 139a of any one of the embodiments of FIGS. 5B, 7, 8, 9, and 10. For example, at least a portion of the cross-sectional structures of the plug portion BP and the bit line BL described above may be similar to the cross-sectional structure of the conductive structure (139 in FIG. 9) described in FIG. 9. In this manner, an example in which at least a portion of the cross-sectional structure of the plug portion BP and the bit line BL described above is similar to the cross-sectional structure of the conductive structure (139 in FIG. 9) described in FIG. 9 will be described with reference to FIG. 18. FIG. 18 is a cross-sectional view conceptually illustrating an area taken along line I-I' of FIG. 13.

Referring to FIG. 18, a plug portion (BPa) may include a metal-semiconductor compound layer 250 and a lower portion 352L extending upward and in contact with the metal-semiconductor compound layer 250 on the metal-semiconductor compound layer 250.

A bit line (BLa) may include an upper portion 352U extending from the lower portion 352L, a material layer 351 disposed between the upper portion 352U and an upper surface of the insulating buffer pattern 231, and an upper material layer 354 on the upper portion 352U.

The bit line BLa may further include an intermediate material layer 353 between the upper portion 352U and the upper material layer 354. The lower portion 352L and the upper portion 352U may be integrally formed. Accordingly, the lower portion 352L and the upper portion 352U may be formed as one continuous material layer which may form a lower material layer. The upper material layer 354 may be formed of the same material as the upper material layer 136c in FIG. 9, the intermediate material layer 353 may be formed of the same material as the intermediate material layer 134c in FIG. 9, the lower material layer including the lower portion 352L and the upper portion 352U may be formed of the same material as the lower material layer 133c in FIG. 9, and the material layer 351 may be formed of the same material as the upper material layer 127a in FIG. 9.

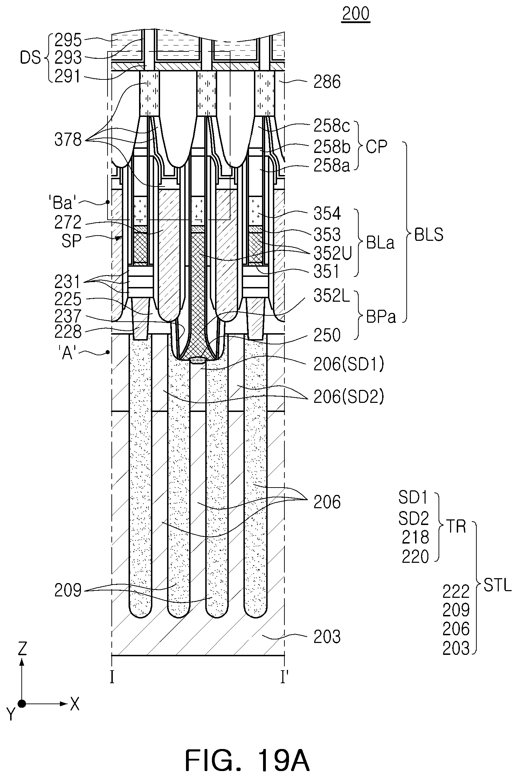

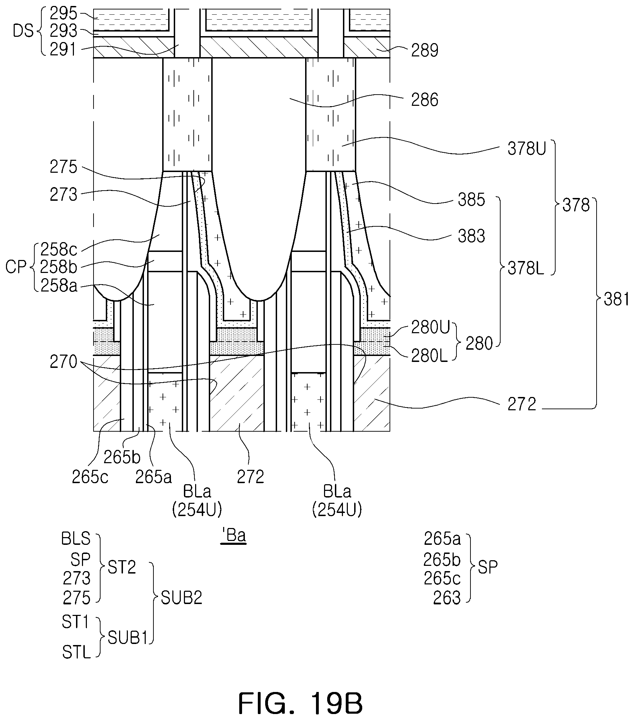

As described above, at least a portion of the cross-sectional structure of the conductive structure 278 may be conceptually similar to the cross-sectional structure of the conductive structures 139 and 139a of any one of the embodiments of FIGS. 5A, 5B, 7, 8, 9, and 10. Hereinafter, with reference to FIGS. 19A and 19B, a modified example of the conductive structure 278 conceptually similar to the conductive structure (139a of FIG. 10) of FIG. 10 will be described. FIG. 19A is a cross-sectional view conceptually illustrating a region taken along line I-I' of FIG. 13, and FIG. 19B is a partially enlarged view of an area indicated by 'Ba' in FIG. 19A.

Referring to FIGS. 19A and 19B, a conductive pattern 378 may be similar to the conductive structure in FIG. 10 (139a of FIG. 10). Accordingly, a contact structure 381 including the conductive pattern 378 and the contact plug 272 may be provided.

The conductive pattern 378 may include a lower region 378L in the second contact hole 275 and an upper region 378U on the lower region 378L. The lower region 378L may include the metal-semiconductor compound layer 280 as described above. The lower region 378L may further include a first material layer 383 and a second material layer 385. The first material layer 383 may contact an upper surface of the metal-semiconductor compound layer 280 and cover a side surface of the second contact hole 275. The second material layer 385 may be formed on the first material layer 383. The first material layer 383 may be formed of the same material as the first material layer (132a of FIG. 10) described with reference to FIG. 10, and the second material layer 385 may be formed of the same material as the second material layer (132b in FIG. 10) described with reference to FIG. 10. The upper region 378U may cover upper surfaces of the first and second material layers 383 and 385 and may cover a portion of the second structure ST2. The upper region 378U may be formed of the same material as the upper region 139Ua described in FIG. 10.

As set forth above, according to example embodiments, a method of forming a metal-semiconductor compound layer in a region exposed by a contact hole may be provided, by not forming a metal layer on the inclined sidewall of the contact hole or by forming a metal layer of about 1 nm or less on the inclined sidewall of the contact hole. As such, since the volume of the contact hole may be significantly secured while forming the metal-semiconductor compound layer, a conductive pattern may be formed without defects such as voids in the contact hole, or a conductive pattern including a low-resistance material may be formed in the contact hole. Therefore, according to example embodiments, since resistance characteristics of a conductive structure including the metal-semiconductor compound layer and the conductive pattern may be improved, electrical characteristics of a semiconductor device including the conductive structure may be improved.

While example embodiments have been illustrated and described above, it will be apparent to those skilled in the art that modifications and variations could be made without departing from the scope of the present inventive concept as defined by the appended claims.

## Claims

1. A method of manufacturing a semiconductor device, comprising:
forming (S110) a structure having a contact hole exposing a first region, at least a portion of the contact hole having an inclined sidewall; and
forming (S30) a metal-semiconductor compound layer on the first region exposed by the contact hole by performing a semiconductor process at a metal-semiconductor compound formation temperature using process gases,
wherein the process gases include a first process gas containing a metal element and a second process gas generating plasma by plasma power applied to the second process gas, and
wherein the forming (S30) the metal-semiconductor compound layer includes:
performing (S40) a first process of exposing the structure to the process gases in a state in which the plasma power is turned off;
after the first process, repeating, two or more times, a second process (S45) and a third process (S50) following the second process, wherein the second process comprises repeatedly alternating between a plasma process for a first duration in which the plasma power is turned on and a process of exposing the structure to the process gases for a second duration in which the plasma power is turned off, and the third process comprises exposing the structure to the process gases while the plasma power is turned off, wherein repeating of the second and third processes forms a preliminary sidewall material layer covering the inclined sidewall of the contact hole and a preliminary upper material layer covering an upper surface of the structure, and wherein a thickness of the preliminary upper material layer is greater than a thickness of the preliminary sidewall material layer; and
after repeating the second process and the third process two or more times, performing a fourth process (S60) of exposing the structure to the process gases while the plasma power is turned off to reduce the thickness of the preliminary upper material layer and form an upper material layer remaining on the upper surface of the structure, and to remove at least a portion of the preliminary sidewall material layer.

2. The method of claim 1, further comprising forming a conductive material layer in the contact hole after forming the metal-semiconductor compound layer,
wherein the conductive material layer is in contact with at least a portion of the inclined sidewall of the contact hole.

3. The method of claim 1, further comprising forming a conductive material layer in the contact hole after forming the metal-semiconductor compound layer,
wherein the preliminary sidewall material layer is formed of a sidewall material layer having a thickness reduced to 1 nm or less by the fourth process, and
wherein the sidewall material layer remains between a sidewall of the contact hole and the conductive material layer.

4. The method of any preceding claim, wherein the process gases further include a third process gas,
wherein the first process gas includes TiCl₄ gas,
wherein the second process gas includes Ar gas, and
wherein the third process gas includes H₂ gas.

5. The method of claim 4, wherein the metal-semiconductor compound layer includes TiSi.

6. The method of claim 4, wherein the process gases further include a fourth process gas containing nitrogen, and
wherein the metal-semiconductor compound layer includes a TiSiN layer.

7. The method of any preceding claim, wherein the metal-semiconductor compound formation temperature is in a range of 400°C to 600°C.

8. The method of any preceding claim, wherein the second process has a duty ratio in a range of 10% to 50%, and
wherein the duty ratio is a ratio of a duration in which the plasma power is turned on to a duration of the second process.

9. The method of any preceding claim, wherein a duration of the third process is 50 to 1000 times greater than a duration of a state in which the plasma power is turned off in the second process.

10. The method of any preceding claim, wherein a duration of the third process is in a range of 3 seconds to 6 seconds.

11. The method of any preceding claim further comprising:
forming at least one conductive material layer on the structure; and
forming a bit line by patterning the at least one conductive material layer,
wherein the structure includes a lower structure and a first structure on the lower structure,
wherein the lower structure includes:
a semiconductor substrate;
an active region on the semiconductor substrate;
an isolation region disposed on the semiconductor substrate and disposed on a side surface of the active region;
a gate trench crossing the active region and extending into the isolation region;
a gate structure in the gate trench; and
a first source/drain region and a second source/drain region disposed in the active region on both sides of the gate structure and spaced apart from each other,
wherein the first structure has the contact hole exposing at least a portion of the first source/drain region,
wherein the first region is the first source/drain region,
wherein the metal-semiconductor compound layer is in contact with the first source/drain region, and
wherein the bit line is electrically connected to the metal-semiconductor compound layer.

12. The method of any of claims 1 to 10, further comprising:
forming at least one conductive material layer on the structure and in contact with the metal-semiconductor compound layer;
patterning the at least one conductive material layer; and
forming a data storage structure on the patterned at least one conductive material layer,
wherein the structure includes:
a cell transistor including a first source/drain region, a second source/drain region, and a gate electrode;
a bit line electrically connected to the first source/drain region;
a contact plug electrically connected to the second source/drain region; and
the contact hole exposing at least a portion of the contact plug,
wherein the first region is the contact plug, and
wherein the metal-semiconductor compound layer is in contact with the contact plug.

13. A semiconductor device comprising:
a structure having a first region (112) and a contact hole (118a) exposing the first region (112); and
a conductive structure including a lower region within the contact hole (118a) and an upper region disposed on the lower region and the structure,
wherein at least a portion of the contact hole (118a) has an inclined sidewall (118b),
wherein the conductive structure includes:
a metal-semiconductor compound layer (121) in contact with the first region (112);
a conductive pattern (130) contacting the metal-semiconductor compound layer (121) within the contact hole (118a), and provided on the structure and covering an upper surface of the structure; and
an upper material layer (127a) between the upper surface of the structure and the conductive pattern (130),
wherein the metal-semiconductor compound layer (121) includes a first metal element and a semiconductor element,
wherein the upper material layer (127a) includes the first metal element;
wherein the thickness of the metal-semiconductor compound layer (121) is greater than the thickness of the upper material layer (127a); and
**characterized in that**
the conductive pattern (130) is in contact with the inclined sidewall (118b) of the contact hole (118a); or
the conductive structure further includes a sidewall material layer (127b) between the conductive pattern (130) and the inclined sidewall (118b) of the contact hole (118a), wherein the thickness of the upper material layer (127a) is greater than the thickness of the sidewall material layer (127b) and
wherein the thickness of the sidewall material layer (127b) is 1 nm or less.

## Patentansprüche

1. Verfahren zum Herstellen einer Halbleitervorrichtung, umfassend:
Bilden (S110) einer Struktur, die ein Kontaktloch aufweist, das einen ersten Bereich freilegt, wobei mindestens ein Abschnitt des Kontaktlochs eine geneigte Seitenwand aufweist; und
Bilden (S30) einer Metall-Halbleiter-Verbundschicht auf dem ersten Bereich, der durch das Kontaktloch freigelegt wird, durch Durchführen eines Halbleiterprozesses bei einer Metall-Halbleiter-Verbundbildungstemperatur unter Verwendung von Prozessgasen,
wobei die Prozessgase ein erstes Prozessgas, das ein Metallelement enthält, und ein zweites Prozessgas beinhalten, das durch Plasmaleistung, die an das zweite Prozessgas angelegt wird, Plasma erzeugt, und
wobei das Bilden (S30) der Metall-Halbleiter-Verbundschicht beinhaltet:
Durchführen (S40) eines ersten Prozesses des Aussetzens der Struktur den Prozessgasen in einem Zustand, in dem die Plasmaleistung abgeschaltet ist;
nach dem ersten Prozess zwei- oder mehrmaliges Wiederholen eines zweiten Prozesses (S45) und eines dritten Prozesses (S50), der auf den zweiten Prozess folgt, wobei der zweite Prozess wiederholtes Abwechseln zwischen einem Plasmaprozess für eine erste Dauer, in der die Plasmaleistung eingeschaltet ist, und einem Prozess des Aussetzens der Struktur den Prozessgasen für eine zweite Dauer, in der die Plasmaleistung abgeschaltet ist, umfasst, und der dritte Prozess Aussetzen der Struktur den Prozessgasen umfasst, während die Plasmaleistung abgeschaltet ist, wobei Wiederholen des zweiten und des dritten Prozesses eine vorläufige Seitenwandmaterialschicht, die die geneigte Seitenwand des Kontaktlochs bedeckt, und eine vorläufige obere Materialschicht bildet, die eine obere Fläche der Struktur bedeckt, und wobei eine Dicke der vorläufigen oberen Materialschicht größer ist als eine Dicke der vorläufigen Seitenwandmaterialschicht; und
nach zwei- oder mehrmaligem Wiederholen des zweiten Prozesses und des dritten Prozesses, Durchführen eines vierten Prozesses (S60) des Aussetzens der Struktur den Prozessgasen, während die Plasmaleistung abgeschaltet ist, um die Dicke der vorläufigen oberen Materialschicht zu reduzieren und eine obere Materialschicht zu bilden, die auf der oberen Fläche der Struktur verbleibt, und mindestens einen Abschnitt der vorläufigen Seitenwandmaterialschicht zu entfernen.

2. Verfahren nach Anspruch 1, das nach Bilden der Metall-Halbleiter-Verbundschicht weiter Bilden einer leitfähigen Materialschicht in dem Kontaktloch umfasst,
wobei die leitfähige Materialschicht mit mindestens einem Abschnitt der geneigten Seitenwand des Kontaktlochs in Kontakt steht.

3. Verfahren nach Anspruch 1, das nach Bilden der Metall-Halbleiter-Verbundschicht weiter Bilden einer leitfähigen Materialschicht in dem Kontaktloch umfasst,
wobei die vorläufige Seitenwandmaterialschicht aus einer Seitenwandmaterialschicht gebildet wird, die eine Dicke aufweist, die durch den vierten Prozess auf 1 nm oder weniger reduziert wird, und
wobei die Seitenwandmaterialschicht zwischen einer Seitenwand des Kontaktlochs und der leitfähigen Materialschicht verbleibt.

4. Verfahren nach einem vorstehenden Anspruch, wobei die Prozessgase weiter ein drittes Prozessgas beinhalten,
wobei das erste Prozessgas TiCl₄-Gas beinhaltet,
wobei das zweite Prozessgas Ar-Gas beinhaltet, und
wobei das dritte Prozessgas H₂-Gas beinhaltet.

5. Verfahren nach Anspruch 4, wobei die Metall-Halbleiter-Verbundschicht TiSi beinhaltet.

6. Verfahren nach Anspruch 4, wobei die Prozessgase weiter ein viertes Prozessgas beinhalten, das Stickstoff enthält, und
wobei die Metall-Halbleiter-Verbundschicht eine TiSiN-Schicht beinhaltet.

7. Verfahren nach einem vorstehenden Anspruch, wobei die Bildungstemperatur des Metall-Halbleiter-Verbunds in einem Bereich von 400 °C bis 600 °C liegt.

8. Verfahren nach einem vorstehenden Anspruch, wobei der zweite Prozess ein Lastverhältnis in einem Bereich von 10 % bis 50 % aufweist, und
wobei das Lastverhältnis ein Verhältnis einer Dauer, in der die Plasmaleistung eingeschaltet ist, zu einer Dauer des zweiten Prozesses ist.

9. Verfahren nach einem vorstehenden Anspruch, wobei eine Dauer des dritten Prozesses 50 bis 1000 Mal größer ist als eine Dauer eines Zustands, in dem die Plasmaleistung im zweiten Prozess abgeschaltet ist.

10. Verfahren nach einem vorstehenden Anspruch, wobei eine Dauer des dritten Prozesses in einem Bereich von 3 Sekunden bis 6 Sekunden liegt.

11. Verfahren nach einem vorstehenden Anspruch, weiter umfassend:
Bilden mindestens einer leitfähigen Materialschicht auf der Struktur; und
Bilden einer Bitleitung durch Mustern der mindestens einen leitfähigen Materialschicht,
wobei die Struktur eine untere Struktur und eine erste Struktur auf der unteren Struktur beinhaltet,
wobei die untere Struktur beinhaltet:
ein Halbleitersubstrat;
einen aktiven Bereich auf dem Halbleitersubstrat;
einen Isolierbereich, der auf dem Halbleitersubstrat angeordnet und auf einer Seitenfläche des aktiven Bereichs angeordnet ist;
einen Gate-Graben, der den aktiven Bereich quert und sich in den Isolierbereich erstreckt;
eine Gate-Struktur in dem Gate-Graben; und
einen ersten Source-/Drain-Bereich und einen zweiten Source-/Drain-Bereich, die im aktiven Bereich auf beiden Seiten der Gate-Struktur angeordnet und voneinander beabstandet sind,
wobei die erste Struktur das Kontaktloch aufweist, das mindestens einen Abschnitt des ersten Source-/Drain-Bereichs freilegt,
wobei der erste Bereich der erste Source-/Drain-Bereich ist,
wobei die Metall-Halbleiter-Verbundschicht mit dem ersten Source-/Drain-Bereich in Kontakt steht, und
wobei die Bitleitung elektrisch mit der Metall-Halbleiter-Verbundschicht verbunden ist.

12. Verfahren nach einem der Ansprüche 1 bis 10, weiter umfassend:
Bilden mindestens einer leitfähigen Materialschicht auf der Struktur und in Kontakt mit der Metall-Halbleiter-Verbundschicht;
Mustern der mindestens einen leitfähigen Materialschicht; und
Bilden einer Datenspeicherstruktur auf der gemusterten mindestens einen leitfähigen Materialschicht,
wobei die Struktur beinhaltet:
einen Zellentransistor, der einen ersten Source-/Drain-Bereich, einen zweiten Source-/Drain-Bereich und eine Gate-Elektrode beinhaltet;
eine Bitleitung, die elektrisch mit dem ersten Source-/Drain-Bereich verbunden ist;
einen Kontaktstecker, der elektrisch mit dem zweiten Source-/Drain-Bereich verbunden ist; und
das Kontaktloch, das mindestens einen Abschnitt des Kontaktsteckers freilegt,
wobei der erste Bereich der Kontaktstecker ist, und
wobei die Metall-Halbleiter-Verbundschicht mit dem Kontaktstecker in Kontakt steht.

13. Halbleitervorrichtung, umfassend:
eine Struktur, die einen ersten Bereich (112) und ein Kontaktloch (118a) aufweist, das den ersten Bereich (112) freilegt; und
eine leitfähige Struktur, die einen unteren Bereich innerhalb des Kontaktlochs (118a) und einen oberen Bereich beinhaltet, der auf dem unteren Bereich und der Struktur angeordnet ist,
wobei mindestens ein Abschnitt des Kontaktlochs (118a) eine geneigte Seitenwand (118b) aufweist,
wobei die leitfähige Struktur beinhaltet:
eine Metall-Halbleiter-Verbundschicht (121) in Kontakt mit dem ersten Bereich (112);
ein leitfähiges Muster (130), das die Metall-Halbleiter-Verbundschicht (121) innerhalb des Kontaktlochs (118a) kontaktiert und auf der Struktur vorgesehen ist und eine obere Fläche der Struktur bedeckt; und
eine obere Materialschicht (127a) zwischen der oberen Fläche der Struktur und dem leitfähigen Muster (130),
wobei die Metall-Halbleiter-Verbundschicht (121) ein erstes Metallelement und ein Halbleiterelement beinhaltet,
wobei die obere Materialschicht (127a) das erste Metallelement beinhaltet;
wobei die Dicke der Metall-Halbleiter-Verbundschicht (121) größer ist als die Dicke der oberen Materialschicht (127a); und
**dadurch gekennzeichnet, dass** das leitfähige Muster (130) mit der geneigten Seitenwand (118b) des Kontaktlochs (118a) in Kontakt steht; oder
die leitfähige Struktur weiter eine Seitenwandmaterialschicht (127b) zwischen dem leitfähigen Muster (130) und der geneigten Seitenwand (118b) des Kontaktlochs (118a) beinhaltet, wobei die Dicke der oberen Materialschicht (127a) größer ist als die Dicke der Seitenwandmaterialschicht (127b), und
wobei die Dicke der Seitenwandmaterialschicht (127b) 1 nm oder weniger beträgt.

## Revendications

1. Procédé de fabrication d'un dispositif semi-conducteur, comprenant :
la formation (S110) d'une structure présentant un trou de contact exposant une première région, au moins une partie du trou de contact présentant une paroi latérale inclinée ; et
la formation (S30) d'une couche de composé métal-semiconducteur sur la première région exposée par le trou de contact en effectuant un processus semiconducteur à une température de formation de composé métal-semiconducteur en utilisant des gaz de processus,
dans lequel les gaz de processus incluent un premier gaz de processus contenant un élément métallique et un deuxième gaz de processus générant du plasma par la puissance plasma appliquée au deuxième gaz de processus, et
dans lequel la formation (S30) de la couche de composé métal-semiconducteur inclut :
la réalisation (S40) d'un premier processus d'exposition de la structure aux gaz de processus dans un état, dans lequel la puissance du plasma est désactivée ;
après le premier processus, la répétition, deux fois ou plus, d'un deuxième processus (S45) et d'un troisième processus (S50) faisant suite au deuxième processus, dans lequel le deuxième processus comprend l'alternance répétée entre un processus de plasma pendant une première durée, pendant laquelle la puissance du plasma est activée et un processus d'exposition de la structure aux gaz de processus pendant une deuxième durée, pendant laquelle la puissance du plasma est désactivée, et le troisième processus comprend l'exposition de la structure aux gaz de processus lorsque la puissance du plasma est désactivée, dans lequel la répétition des deuxième et troisième processus forme une couche préliminaire de matériau de paroi latérale recouvrant la paroi latérale inclinée du trou de contact et une couche préliminaire de matériau supérieur recouvrant une surface supérieure de la structure, et dans lequel une épaisseur de la couche préliminaire de matériau supérieur est supérieure à une épaisseur de la couche préliminaire de matériau de paroi latérale ; et
après la répétition du deuxième processus et du troisième processus deux fois ou plus, la réalisation d'un quatrième processus (S60) consistant à exposer la structure aux gaz de processus lorsque la puissance du plasma est désactivée pour réduire l'épaisseur de la couche préliminaire de matériau supérieur et former une couche de matériau supérieur restant sur la surface supérieure de la structure, et pour supprimer au moins une partie de la couche préliminaire de matériau de paroi latérale.

2. Procédé selon la revendication 1, comprenant en outre la formation d'une couche de matériau conducteur dans le trou de contact après la formation de la couche de composé métal-semiconducteur,
dans lequel la couche de matériau conducteur est en contact avec au moins une partie de la paroi latérale inclinée du trou de contact.

3. Procédé selon la revendication 1, comprenant en outre la formation d'une couche de matériau conducteur dans le trou de contact après la formation de la couche de composé métal-semiconducteur,
dans lequel la couche préliminaire de matériau de paroi latérale est constituée d'une couche de matériau de paroi latérale dont l'épaisseur est réduite à 1 nm ou moins par le quatrième processus, et
dans lequel la couche de matériau de paroi latérale reste entre une paroi latérale du trou de contact et la couche de matériau conducteur.

4. Procédé selon une quelconque revendication précédente, dans lequel les gaz de processus incluent en outre un troisième gaz de processus,
dans lequel le premier gaz de processus inclut du gaz TiCl₄,
dans lequel le deuxième gaz de processus inclut du gaz Ar, et
dans lequel le troisième gaz de processus inclut du gaz_{H2}.

5. Procédé selon la revendication 4, dans lequel la couche de composé métal-semiconducteur inclut du TiSi.

6. Procédé selon la revendication 4, dans lequel les gaz de processus incluent en outre un quatrième gaz de processus contenant de l'azote, et
dans lequel la couche de composé métal-semiconducteur inclut une couche de TiSiN.

7. Procédé selon une quelconque revendication précédente, dans lequel la température de formation du composé métal-semiconducteur est comprise dans une plage entre 400 °C et 600 °C.

8. Procédé selon une quelconque revendication précédente, dans lequel le deuxième processus présente un rapport cyclique compris dans une plage entre 10 % et 50 %, et
dans lequel le rapport cyclique est un rapport entre une durée pendant laquelle la puissance du plasma est activée et une durée du deuxième processus.

9. Procédé selon une quelconque revendication précédente, dans lequel une durée du troisième processus est de 50 à 1000 fois supérieure à une durée d'un état dans lequel la puissance du plasma est désactivée dans le deuxième processus.

10. Procédé selon une quelconque revendication précédente, dans lequel une durée du troisième processus est comprise dans une plage entre 3 secondes et 6 secondes.

11. Procédé selon une quelconque revendication précédente, comprenant en outre :
la formation d'au moins une couche de matériau conducteur sur la structure ; et
la formation d'une ligne binaire en structurant la au moins une couche de matériau conducteur,
dans lequel la structure inclut une structure inférieure et une première structure sur la structure inférieure,
dans lequel la structure inférieure inclut :
un substrat semi-conducteur ;
une région active sur le substrat semi-conducteur ;
une région d'isolation disposée sur le substrat semi-conducteur et disposée sur une surface latérale de la région active ;
une tranchée de porte traversant la zone active et s'étendant dans la région d'isolation ;
une structure de porte dans la tranchée de la porte ; et
une première région source/drain et une seconde région source/drain disposée dans la région active de part et d'autre de la structure de la porte et espacées l'une de l'autre,
dans lequel la première structure présente le trou de contact exposant au moins une partie de la première région source/drain,
dans lequel la première région est la première région source/drain,
dans lequel la couche de composé métal-semiconducteur est en contact avec la première région source/drain et
dans lequel la ligne binaire est reliée électriquement à la couche de composé métal-semiconducteur.

12. Procédé selon l'une quelconque des revendications 1 à 10, comprenant en outre :
la formation d'au moins une couche de matériau conducteur sur la structure et en contact avec la couche de composé métal-semiconducteur ;
la structuration de la au moins une couche de matériau conducteur ; et
la formation d'une structure de stockage de données sur la au moins une couche de matériau conducteur structurée,
dans lequel la structure inclut :
un transistor à cellule incluant une première région source/drain, une seconde région source/drain et une électrode de grille ;
une ligne binaire reliée électriquement à la première région source/drain ;
une fiche de contact reliée électriquement à la seconde région source/drain ; et
le trou de contact exposant au moins une partie de la fiche de contact,
dans lequel la première région est la fiche de contact, et
dans lequel la couche de composé métal-semiconducteur est en contact avec la fiche de contact.

13. Dispositif semi-conducteur comprenant :
une structure présentant une première région (112) et un trou de contact (118a) exposant la première région (112) ; et
une structure conductrice incluant une région inférieure à l'intérieur du trou de contact (118a) et une région supérieure disposée sur la région inférieure et la structure,
dans lequel au moins une partie du trou de contact (118a) présente une paroi latérale inclinée (118b),
dans lequel la structure conductrice inclut :
une couche de composé métal-semiconducteur (121) en contact avec la première région (112) ;
un motif conducteur (130) en contact avec la couche de composé métal-semiconducteur (121) à l'intérieur du trou de contact (118a), et disposé sur la structure et recouvrant une surface supérieure de la structure ; et
une couche de matériau supérieur (127a) entre la surface supérieure de la structure et le motif conducteur (130),
dans lequel la couche de composé métal-semiconducteur (121) inclut un premier élément métallique et un élément semiconducteur,
dans lequel la couche de matériau supérieur (127a) inclut le premier élément métallique ;
dans lequel l'épaisseur de la couche de composé métal-semiconducteur (121) est supérieure à l'épaisseur de la couche de matériau supérieure (127a) ; et
**caractérisé en ce que** le motif conducteur (130) est en contact avec la paroi latérale inclinée (118b) du trou de contact (118a) ; ou
la structure conductrice inclut en outre une couche de matériau de paroi latérale (127b) entre le motif conducteur (130) et la paroi latérale inclinée (118b) du trou de contact (118a), dans lequel l'épaisseur de la couche de matériau supérieur (127a) est supérieure à l'épaisseur de la couche de matériau de paroi latérale (127b) et
dans lequel l'épaisseur de la couche de matériau de paroi latérale (127b) est de 1 nm ou moins.
